# EUROPÄISCHE PATENTSCHRIFT

(11) **EP 2 033 228 B1**
(45) Veröffentlichungstag und Bekanntmachung des Hinweises auf die Patenterteilung: **21.05.2014**
(21) Anmeldenummer: 07722516.7
(22) Anmeldetag: 02.06.2007
(51) Int. Cl.: H01L 31/0224

(54) **EINSEITIG KONTAKTIERTE SOLARZELLE MIT DURCHKONTAKTIERUNGEN UND VERFAHREN ZUR HERSTELLUNG**
SINGLE-SIDED CONTACT SOLAR CELL WITH PLATED-THROUGH HOLES AND METHOD FOR PRODUCING IT
CELLULE SOLAIRE À CONTACT UNILATÉRAL ET TROUS MÉTALLISÉS ET PROCÉDÉ DE FABRICATION

(30) Priorität: 10.06.2006 DE 102006027737
(43) Veröffentlichungstag der Anmeldung: 11.03.2009
(73) Patentinhaber: Helmholtz-Zentrum Berlin für Materialien und Energie GmbH, 14109 Berlin (DE)
(72) Erfinder: STANGL, Rolf, 12435 Berlin (DE); GALL, Stefan, 13597 Berlin (DE)
(74) Vertreter: Rudolph, Margit
(86) Internationale Anmeldenummer: PCT/DE2007/001007
(87) Internationale Veröffentlichungsnummer: WO 2007/140763

(56) Entgegenhaltungen:
- WO-A-2006/029250
- US-A- 3 903 427
- US-A1- 2004 261 834

## Beschreibung

Die Erfindung bezieht sich auf eine einseitig kontaktierte Solarzelle aus zumindest einer mit Durchkontaktierungen strukturierten Absorberschicht und einer auf einer Seite der Absorberschicht ganzflächig angeordneten Emitterschicht aus Halbleitermaterialien unterschiedlicher Dotierung, wobei überschüssige Ladungsträger in der Absorberschicht durch Lichteinfall erzeugt, am pn-Übergang zwischen Absorber- und Emitterschicht getrennt und über zwei, gemeinsam auf einer Seite der Absorberschicht angeordnete, elektrisch von außen kontaktierte und gegeneinander isolierte Kontaktsysteme gesammelt und abgeleitet werden, wobei das eine Kontaktsystem auf der Absorberschicht angeordnet und als Kontaktgitter, das zumindest auf seiner gesamten Oberseite mit einer Isolationsschicht bedeckt und mit den Durchkontaktierungen an ihren einen Enden elektrisch leitend verbunden ist, und das andere Kontaktsystem als ganzflächige Kontaktschicht ausgebildet ist. Weiterhin bezieht sich die Erfindung auf Verfahren zur Herstellung entsprechender Solarzellen. Die Absorberschichten können als selbsttragende Wafer oder als Dünnschicht auf einem Substrat oder Superstrat ausgeführt sein.

Solarzellen sind Bauelemente, die Licht in elektrische Energie umwandeln. Üblicherweise bestehen sie aus Halbleitermaterialien, die Bereiche oder Schichten unterschiedlicher Leitfähigkeit für positive und negative Ladungsträger, n-typ oder. p-typ leitende Bereiche, enthalten. Die Bereiche werden als Emitter und Absorber bezeichnet. Durch einfallendes Licht erzeugte positive und negative Überschuss-Ladungsträger werden am pn-Übergang zwischen Emitter- und Absorberschicht getrennt und können durch mit den jeweiligen Bereichen elektrisch leitend verbundenen Kontaktsystemen gesammelt und abgeführt werden. Zur nutzbaren elektrischeb Leistung von Solarzellen tragen entsprechend nur solche überschüssigen Ladungsträger bei, die die Kontaktsysteme erreichen und nicht vorher mit einem jeweils gegenpoligen Ladungsträger rekombinieren.

Einseitig kontaktierte Solarzellen weisen beide Kontaktsysteme zum getrennten Einsammeln der überschüssigen Ladungsträger aus der Absorberschicht auf einer gemeinsamen Seite auf. Dies hat zunächst grundsätzlich den Vorteil, dass nur eine Seite zur Kontaktierung bearbeitet werden muss. Im Sinne der vorliegenden Erfindung wird der Begriff "Vorderseitenkontaktierung" verwendet, wenn sich beide Kontaktsysteme auf der im Betrieb dem Lichteinfall ausgesetzten Seite (Vorderseite) der Solarzelle befinden. Der Begriff "Rückseitenkontaktierung" wird hingegen verwendet, wenn beide Kontaktsysteme auf der im Betrieb nicht dem Lichteinfall ausgesetzten Seite (Rückseite) der Solarzelle angeordnet sind. Außerdem wird noch der Begriff "Oberseite" im Zusammenhang mit der Solarzelle verwendet. Hiermit ist die im Betrieb und vor allem auch bei der Herstellung zugängliche Seite der Solarzelle gemeint. Im Falle eines Absorberwafers sind beide Seiten der Solarzelle zugänglich und damit als Oberseiten zu bezeichnen. Im Falle von dünnschichtbasierten Solarzellen mit einem Substrat oder Superstrat wird jeweils die jeweils dem Substrat oder Superstrat gegenüber liegende Seite der Solarzelle mit "Oberseite" bezeichnet. Bei einem Substrat handelt es sich dabei um die Vorderseite, bei einem Superstrat um die Rückseite.

Wichtig bei der Anordnung der Kontaktsysteme ist in erster Linie ihre Effizienz bei der Ladungsträgersammlung. Ist die Absorberschicht der Solarzelle von hinreichend guter elektronischer Qualität, d.h. ist die effektive Bulk-Diffusionslänge der Minoritäts-Ladungsträger wesentlich größer als die Schichtdicke der Absorberschicht, so kann die Emitterschicht in der Regel vorteilhafterweise auf der Rückseite der Solarzelle liegen. Im Falle einer Rückseitenkontaktierung ergeben sich dann insbesondere die Vorteile, dass erstens keine Abschattungsverluste durch ein Kontaktsystem auftreten, was zu einer Effizienzverbesserung der Solarzelle führt, und zweitens eine einfache ganzflächige Bedeckung der im Betrieb dem Lichteinfall auszusetzenden Seite der Solarzelle mit weiteren funktionellen Schichten möglich ist. Hierbei kann es sich beispielsweise um eine frontseitige Feldpassivierungsschicht (Front Surface Field, FSF) zur Rückstreuung der Minoritäts-Ladungsträger oder eine zusätzliche Antireflexschicht handeln. Ist die Absorberschicht jedoch von relativ geringer elektronischer Qualität, d.h. ist die effektive Bulk-Diffusionslänge der Minoritäts-Ladungsträger kleiner als oder in der Größenordnung der Schichtdicke der Absorberschicht, so sollte die Emitterschicht vorteilhafterweise auf der Vorderseite der Solarzelle liegen. Alle Minoritäts-Ladungsträger der Absorberschicht, die in einer Tiefe generiert werden, die kleiner als die effektive Bulk-Diffusionslänge der Absorberschicht ist, können dann zuverlässig gesammelt werden. Bei einer Vorderseitenkontaktierung kann zur effizienz-verbessernden Minoritäts-Ladungsträger-Rückstreuung eine rückseitige Feldpassivierungsschicht (Back Surface Field, BSF) vorgesehen sein (analog bei der Rückseitenkontaktierung eine frontseitige Feldpassivierungsschicht (Front Surface Field, FSF)).

Relevant für Solarzellen nach der Erfindung sind im Stand der Technik einseitige Rückseitenkontaktierungen, die mittels Durchkontaktierungen durch die entsprechend strukturierte Absorberschicht auch die Vorderseite kontaktieren. Hierbei handelt es sich um so genannte Metal-Wrap-Through (MWT) bzw. Emitter-Wrap-Through (EWT) Technologien, bei denen ein metallischer Steg, der über ein Kontaktgitter die vorderseitige Emitterschicht kontaktiert, bzw. die vorderseitige Emitterschicht selbst durch die Absorberschicht hindurch mit einem entsprechenden Kontaktsystem auf der Rückseite der Solarzelle durchkontaktiert werden.

### Stand der Technik

Einseitig vorderseitig kontaktierte,Solarzellen mit Durchkontaktierungen sind bisher in Ermangelung eines technologisch einfachen und effizienten Herstellungsverfahrens nicht realisiert wbrden. Aus dem Stand der Technik sind ausschließlich einseitig, rückseitig kontaktierte Solarzellen mit Durchkontaktierungen bekannt. Ein guter Überblick über rückseitenkontaktierte Solarzellen mit Durchkontaktierungen ist der **Veröffentlichung** von E.V.Kerschaver et al.: "Back-contact Solar Cells: A Review" (Prog. Photovolt: Res. Appl., 25.05.2005, published online in Wileys InterScience D0I:10.1002/pip.657) zu entnehmen. US 3 903 427 offenbart eine einseitig kontaktierte Solarzelle

Eine Emitter-Wrap-Through Technologie für waferbasierte Solarzellen wird in der US 5.468.652 offenbart. Hieraus ist eine Punktkontaktierung bekannt, bei der mit einem Laser durch die Emitterschicht, die auf der Vorderseite der Absorberschicht angeordnet ist, und durch die Absorberschicht gebohrte Löcher mit einem Kontaktsystem auf der Waferrückseite kontaktiert werden. Die Emitter- als auch eine optionale BSF- Schicht wird über Diffusion erzeugt. Dabei ist das andere Kontaktsystem zur Ableitung der Minoritäts-Ladungsträger gegenüber der Waferrückseite isoliert und mit dem einen Kontaktsystem zur Ableitung der Majoritäts-Ladungsträger, das nicht gegenüber der Waferrückseite isoliert ist, verschachtelt (interdigitierend) angeordnet. Insbesondere ist eine rückseitige strukturierende Trennung von Emitter- und Absorber- bzw. BSF- Schicht einschließlich der beiden interdigitierenden Kontaktsysteme nötig. Dies erfolgt hier durch selektives Entfernen einer isolierenden Oxidschicht und selektive Diffusion.

Eine alternative Emitter-Wrap-Through Technologie für waferbasierte Solarzellen ist als RISE-EWT-Solarzelle bekannt (vergleiche **Veröffentlichung** von P. Engelhardt et al.: "The RISE-EWT Solar Cell - A New Approach Towards Simple - High Efficiency Silicon Solar Cells", 15th International Photovoltaic Science and Engineering Conference, Shanghai, China, 2005, p. 802-803). Die rückseitige strukturierende Trennung von Emitter- und Absorber- bzw. BSF-Schicht einschließlich der beiden interdigitierenden Kontaktsysteme auf der Waferrückseite erfolgt hierbei über eine Laserstrukturierung (Erzeugung von kammartigen Vertiefungen), sodass rückseitig ganzflächig ein Metall abgeschieden werden kann, das dann die beiden Kontaktsysteme ausbildet.

Weiterhin ist aus der DE 696 31 815 T2 eine waferbasierte rückseitenkontaktierte kristalline Homo-Solarzelle ohne Durchkontaktierungen bekannt, bei der ein mit einer Isolationsschicht umgebenes Kontaktgitter vorgesehen ist, über dem unter Zwischenlage einer Isolationsschicht eine ganzflächige Kontaktschicht angeordnet ist. Bei dieser Homokontakt-Solarzelle erfolgt jedoch eine Strukturierung der Emitterschicht durch Gegendotierung der Absorberschicht mit Dotanden aus dem Kontaktgitter. Die Emitterschicht ist somit nicht als eigenständige funktionelle Schicht ausgebildet, sondern wird von integrierten kleinen Bereichen in der Absorberschicht direkt unter dem Kontaktgitter ausgebildet. Durch die aufwändigen Diffusionsvorgänge kann kein scharfer p-n-Übergang geschaffen werden. Die Isolationsschicht auf dem Metallgitter kann durch ein selektives Oxid, beispielsweise Aluminiumoxid, ausgebildet werden.

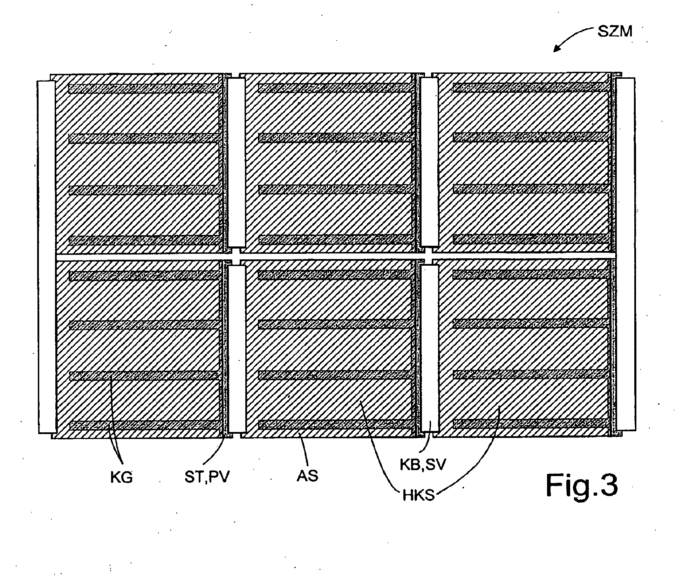

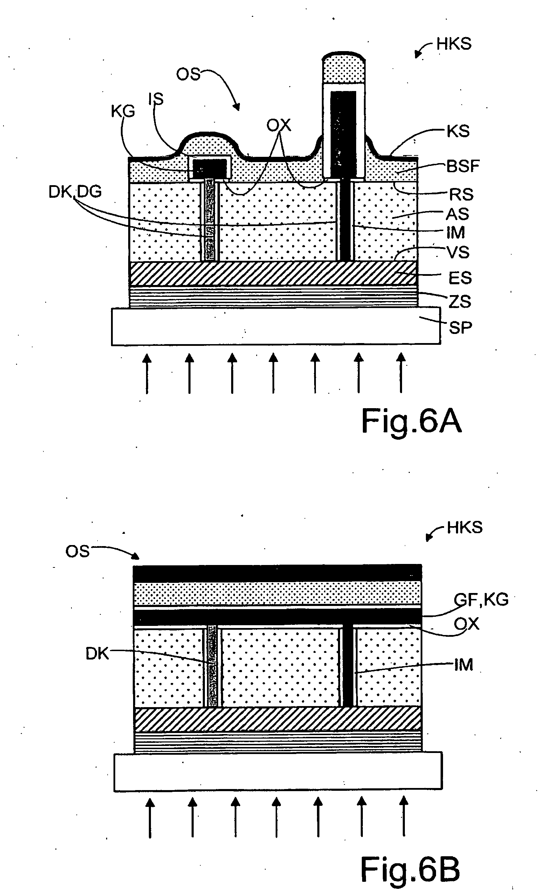

In der DE 198 54 269 A1 wird eine dünnschichtbasierte Hetero-Solarzelle mit einem Substrat und mit Durchkontaktierungen beschrieben, bei der das eine Kontaktsystem zwar als Kontaktgitter ausgebildet, aber direkt in die Rückseite der Absorberschicht vor einem elektrisch leitfähigen Substrat integriert ist. Das andere Kontaktsystem ist als ganzflächige Kontaktschicht ausgebildet und auf der Rückseite des elektrisch leitenden Substrats angeordnet (Figur 6). Die elektrische Leitfähigkeit des Substrats ist daher funktionswesentlich. Das Kontaktgitter zwischen Absorberschicht und Substrat ist vollständig von einer Isolationsschicht ummantelt, um eine direkte und indirekte elektrisch leitende Verbindung der Absorberschicht mit dem Kontaktgitter zu vermeiden. Die elektrisch leitende Verbindung des Kontaktgitters ausschließlich zur Emitterschicht ergibt sich durch Durchkontaktierungen durch die Absorberschicht in Form von Durchgangsöffnungen durch die ganzflächig ausgebildeten Emitter-und Absorberschichten. Die Durchgangsöffnungen sind teilweise mit Emittermaterial und teilweise mit Kontaktgittermaterial angefüllt und daher ent-sprechend schwierig technologisch zu realisieren In der Figur 3 ist eine Ausführungsform mit zwei interdigitierenden Kontaktsystemen dargestellt, die in einer Isolationsschicht eingebettet direkt auf dem Substrat aufgebracht werden. Zur Kontaktierung werden zwei unterschiedliche Punktkontaktierungen benötigt. Hierzu werden Löcher durch die Emitter-, die Absorber- und die Isolations- Schicht erzeugt, die im Falle einer Punktkontaktierung der Emitterschicht zweistufig erzeugt und mit Emittermaterial ausgekleidet werden müssen, im Falle einer Punktkontaktierung der Absorberschicht wird selektiv nur der untere Bereich der Löcher metallisch befüllt. Alternativ kann auch das Kontaktsystem, das für die Kontaktierung der Absorberschicht vorgesehen ist, unisoliert auf dem Substrat abgeschieden werden. Es wird dann mit der Abscheidung der Absorberschicht direkt kontaktiert. Dies spart die Punktkontaktierung der Absorberschicht, dafür müssen aber die Kontaktschichten auf dem Substrat entsprechend isolierend/nicht isolierend strukturiert werden. In allen Ausführungsformen liegen jedoch beide Kontaktsysteme auf der Solarzellenunterseite (die dem Substrat am nächsten liegende Seite) unterhalb der aktiven Solarzellenschichten und sind damit entsprechend schwer herzustellen und zu kontaktieren.

Eine dünnschichtbasierte Superstrat-Solarzelle in einer n⁺⁺ip-Dotier-Konfiguration mit einer Rückseitenkontaktierung mit zwei Kontaktierungs-Typen für die n⁺⁺ -Schicht und die p-Schicht ist in WO 03/019674 A1 offenbart. Die intrinsisch dotierte i-Schicht kann hierbei als Absorberschicht und die n⁺⁺-bzw. p-dotierten Schichten als Emitterschicht bzw. BSF-Schicht aufgefasst werden. Beide Kontaktsysteme liegen hier auf der Solarzellenoberseite (die am weitesten vom Superstrat entfernte Seite, die gleichzeitig die Solarzellenrückseite darstellt) oberhalb der aktiven Solarzellenschichten (bestehend aus Emitter- Absorber- und Feldpassivierungs-Schicht) und werden durch Punktkontaktierungen durch eine Isolationsschicht hindurch an die p-Schicht bzw. durch die Isolationsschicht, die p-Schicht und die i-Schicht hindurch an die n++ Schicht durchkontaktiert. Die Punktkontaktierungen sind im Falle der p-Schicht metallisch, im Falle der n⁺⁺ -Schicht müssen die Löcher mit einem Emitter-material (einer n-Schicht) ausgekleidet werden. Die unterschiedlichen Punktkontaktierungen werden nun über Kontaktstreifen auf der Solarzellen-oberseite zu den zwei strukturierten Kontaktsystemen zusammengefasst. Insbesondere wird hier auch die Möglichkeit einer integrierten Serien- und Parallel-Verschaltung eines fertigen Solarzellen-Moduls angegeben.

### Aufgabenstellung

Die **Aufgabe** für die Erfindung ist darin zu sehen, eine einseitig kontaktierte Solarzelle mit Durchkontaktierungen anzugeben, die in technologisch stark vereinfachender Weise sowohl für waferbasierte Solarzellen als auch für Dünnschicht-Solarzellen in der Substrat oder Superstrat Konfiguration realisierbar ist. Im Falle einer waferbasierten Solarzelle bedeutet dies, dass mit Ausnahme der einfachen Erzeugung von Löchern im Wafer keine weiteren Strukturierungsmaßnahmen erforderlich sein sollen. Im Falle von Dünnschicht-Solarzellen bedeutet dies, dass nur noch ein Punktkontaktierungs-Typ benötigt werden soll. Insgesamt sollen der Aufbau und die Herstellung der Kontaktsysteme erheblich vereinfacht werden. Dabei sollen sowohl für waferbasierte Solarzellen als auch für dünnschichtbasierte Solarzellen alle aktiven Solarzellenschichten sowie die zweite Kontaktschicht ganzflächig abgeschieden werden. Dabei sollen trotzdem zuverlässig arbeitende Solarzellen mit einem hohen Wirkungsgrad durch Vorsehen von Feldpassivierungsschichten zur Verfügung gestellt werden. Weiterhin sollen auch technologisch sinnvolle Vorderseitenkontaktierungen sowie Durchkontaktierungen von Feldpassivierungsschichten angegeben werden. Verfahren zur Herstellung derartiger Solarzellen sollen effizient, kostengünstig und einfach anpassbar in ihren Ausgestaltungsmöglichkeiten sein.

Die erfindungsgemäße **Lösung** für diese Aufgabe ist dem Erzeugnisanspruch und den nebengeordneten Verfahrensansprüchen zu entnehmen. Vorteilhafte Modifikationen werden in den jeweils zugeordneten Unteransprüchen aufgezeigt und im Folgenden im Zusammenhang mit der Erfindung näher erläutert.

Die erfindungsgemäße Solarzelle weist zwei einander gegenüberliegende, elektrisch leitende funktionelle Solarzellenschichten, die Emitterschicht und eine Feldpassivierungsschicht, auf, die sich getrennt auf Vorder- und Rückseite der Absorberschicht befinden, wobei eine der beiden funktionellen Solarzellenschichten durch die Absorberschicht durchkontaktiert wird. Die durchkontaktierten Stellen werden über ein metallisches Kontaktgitter elektrisch leitend miteinander verbunden und auf der Oberfläche des Kontaktgitters elektrisch isoliert. Das nach außen isolierte Kontaktgitter befindet sich dann zwischen der Absorberschicht und einer funktionellen Solarzellenschicht, die ganzflächig abgeschieden wird. Diese funktionelle Solarzellenschicht (die nicht durchkontaktierte wurde) ist ganzflächig mit einer Kontaktschicht kontaktiert. Eine aufwändige Strukturierung oder eine beidseitige Isolierung der Kontaktsysteme entfällt damit völlig. Auch sind beide funktionelle Solarzellenschichten, die Emitter- und die Feldpassivierungs-schicht, stets unstrukturiert, wodurch der Herstellungsaufwand noch weiter verringert und der Effizienzgrad noch weiter gesteigert werden kann. Die Strukturierung der Absorberschicht beschränkt sich auf die Erzeugung geometrisch einfachster Durchkontaktierungen, eine integrierende Strukturierung des Kontaktgitters entfällt. Ebenfalls treten aufwändige Bereichs-strukturierungen der Emitterschicht oder der Feldpassivierungsschicht bei der Solarzelle nach der Erfindung nicht auf. Beide Kontaktsysteme sind immer durch eine Isolationsschicht und einer weiteren funktionelle Solarzellenschicht (Emitter- oder Feldpassivierungsschicht) voneinander getrennt, befinden sich aber immer auf der zur Herstellung leicht zugänglichen Oberseite (bei dünnschichtbasierten Solarzelle die dem Substrat oder Superstrat gegenüber liegende Seite) der Solarzelle. Die verschiedenen alternativen Ausführungsformen der Erfindung begründen sich auf eine Ausführung als selbsttragende, waferbasierten Solarzelle bzw. auf eine Ausführung als Dünnschicht-Solarzelle in alternativer Substrat- oder Superstrat-Konfiguration und einer alternativen Emitter- oder Feldpassivierungsschicht-Durchkontaktierung mit vorderseitig oder rückseitig (bezüglich des Lichteinfalls) angeordneter Emitterschicht.

Mit Hilfe der Emitter-Wrap-Through-Technologien kann bei der Erfindung eine Rückseitenkontaktierung bei vorderseitig angeordneter Emitterschicht realisiert werden. Wird bei der Erfindung hingegen eine Feldpassivierungsschicht durchkontaktiert (FSF- bzw. BSF -Wrap-Through), so können ohmsche Verluste der Majoritätsladungsträger, die nun nicht mehr durch die Absorberschicht, sondern über die FSF-Schicht zu dem Kontaktgitter fließen, minimiert werden unter der Voraussetzung, dass die durchkontaktierte Feldpassivierungsschicht besser leitet als die Absorberschicht. Insbesondere für dünnschichtbasierte Solarzellen, die auf einem Substrat oder Superstrat abgeschieden werden, kann auch eine Vorderseiten-Kontaktierung vorteilhaft sein, z.B. wenn mit der zuletzt abgeschiedenen funktionalen Solarzellenschicht (Emitterschicht oder Feldpassivierungsschicht) die Absorbergrenzfläche am besten passiviert werden kann. Die ganzflächige, die Emitterschicht oder Feldpassivierungsschicht kontaktierende Kontaktschicht wird dann transparent ausgeführt. Bei einer dünnschichtbasierten Solarzelle befinden sich bei der Erfindung beide Kontaktsysteme immer auf der Oberseite, d.h. auf der leicht zugänglichen Seite der Solarzelle, die Kontakte sind also insbesondere nicht vergraben und somit ebenfalls leicht zugänglich, insbesondere auch im Hinblick auf eine spätere Serien- bzw. Parallelverschaltung mit Hilfe von einfachen zusätzlichen Strukturierungsschritten. Bei waferbasierten Solarzellen sind beide Seiten der Absorberschicht grundsätzlich leicht zugänglich und können als Oberseite zur Anordnung der beiden Kontaktsysteme dienen.

Eine Durchkontaktierung von Feldpassivierungsschichten (FSF-Wrap-Through bzw. BSF-Wrap-Through) oder beider Kontaktsysteme auf die Vorderseite der Solarzelle ist aus dem Stand der Technik nicht bekannt. Zudem unterscheiden sich die bekannten Durchkontaktierungen fundamental von der vorliegenden Erfindung in dem Sinne, dass sich gemäß dem Stand der Technik beide Kontaktsysteme immer "außerhalb" der aktiven Solarzellenschichten (bestehend aus Emitter- Absorber- und Feldpassivierungs-Schicht) befinden, während sich im Sinne der Erfindung das Kontaktgitter immer "innerhalb" der Solarzellenschichten, d.h. entweder zwischen der Absorber- und der Emitter-Schicht oder zwischen der Absorber- und einer Feldpassivierungs-Schicht befindet. Zudem liegen beide Kontaktsysteme immer auf der technologisch leicht zugänglichen Oberseite der Solarzelle. Im Sinne der Erfindung bedeutet dies insbesondere im Falle einer Durchkontaktierung von dünnschichtbasierten Solarzellen, dass nun nur noch ein Kontaktierungs-Typ benötigt wird (Durchkontaktierung der Solarzellenschicht, die sich auf der Unterseite, d.h. dem Substrat/Superstrat am nächsten liegenden Seite der Absorberschicht befindet), und nicht mehr zwei Kontaktierungs-Typen (Durchkontaktierung der Emitterschicht und Kontaktierung der Absorber- bzw. der Feldpassivierungsschicht). Im Falle einer waferbasierten Solarzelle bedeutet dies, dass nun keine weiteren aufwendigen Strukturierungen der Absorberschicht oder der Kontaktsysteme vorgenommen werden muss, da das zweite Kontaktsystem (die Kontaktschicht) ganzflächig abgeschieden werden kann. Mit Ausnahme der einfachen Erzeugung von Löchern im Wafer sind keine weiteren Strukturierungsmaßnahmen nötig und alle aktiven Solarzellenschichten können ganzflächig abgeschieden werden.

### (A) Rückseitenkontaktierte, waferbasierte Solarzellen

Eine Solarzelle, bei der sich die Emitterschicht auf der Rückseite befindet, kann nur dann hohe Wirkungsgrade liefern, wenn die Bulk-Diffusionslänge der Minoritätsladungsträger des Wafers wesentlich größer als die Waferdicke ist. Es wird dann in der Regel ein Wafer von sehr hoher elektronischer Qualität (FZ-Wafer) benötigt. Bei Wafern mit moderater elektronischer Qualität (CZ, poly-cSi, EFG Wafer) sollte die Emitterschicht auf der Vorderseite platziert werden. Es kann dann jedoch wiederum die Rückseitenkontaktierung nach der Erfindung eingesetzt werden, indem die Emitterschicht durch Durchgangsöffnungen (Löcher oder Schlitze) im Wafer punktuell/partiell auf die Rückseite der Solarzelle geführt wird ("Emitter-Wrap-Through"-Konzept). Die Durchgangsöffnungen im Wafer werden dann Teil der Emitterschicht, die im Anschluss an die Strukturierung des Wafers auf der Vorderseite der HeteroSolarzelle aufgebracht wird. Beim Verbinden der Durchkontaktierungen der Emitterschicht durch ein Kontaktgitter ist grundsätzlich ein Kurzschluss der Absorberschicht mit dem Kontaktgitter zu verhindern. Entweder sind die Durchgangsöffnungen der geometrischen Form des Kontaktgitters angepasst, bei Kontaktfingern also schlitzförmig, oder es ist eine elektrisch isolierende Schicht (beispielsweise Oxidschicht) auf der Absorberschicht zwischen punktförmigen Durchkontaktierungen vorgesehen.

Wird die als Dünnschicht ausgeführte Emitterschicht auf der Rückseite der Solarzelle belassen, so kann in analoger Weise die frontseitige Passivierungsschicht, wenn diese als frontseitige leitfähige Feldpassivierungsschicht FSF ausgebildet ist,(z.B. a-Si:H), durch Durchkontaktierungen in der Absorberschicht punktuell/partiell auf die Rückseite der Solarzelle geführt werden. Das hiermit neu definierte "FSF-Wrap-Through"-Konzept entspricht grob dem bekannten "Metal-Wrap-Through" -Konzept für rückseitenkontaktierte Solarzellen, wobei anstelle des Metalls eine frontseitige Feldpassivierungsschicht FSF durch die Absorberschicht durchkontaktiert wird. Hierdurch können ohmsche Verluste der Majoritätsladungsträger, die nun nicht mehr durch den Wafer als Absorberschicht, sonder über die frontseitige Feldpassivierungsschicht zu dem Kontaktgitter fließen, unter der Voraussetzung minimiert werden, dass die durchkontaktierte frontseitige Feldpassivierungsschicht besser leitet als der Wafer selbst. Der Serienwiderstand und somit der Füllfaktor einer solchermaßen rückseitenkontaktierten Solarzelle mit rückseitiger Emitterschicht lässt sich durch diese Maßnahme verbessern.

Dabei können beide Kontaktsysteme auf die Rückseite des Wafers gelegt werden, ohne dass eine technologisch aufwändige Strukturierung der Emitterschicht oder des Wafers vorgenommen werden muss. Ein bevorzugtes Herstellungsverfahren dafür und vorteilhafte Modifikationen können folgendermaßen aussehen:
■ *Ganzflächiges Erzeugen einer elektrisch isolierenden Schutzschicht auf der Rückseite des Wafers.*
   Der Wafer wird auf seiner Rückseite (im Betrieb lichtabgewandte Seite der Solarzelle) mit einer elektrisch isolierenden Schutzschicht versehen. Diese schützt die Oberfläche der Waferrückseite während der späteren Strukturierung des Wafers und wird später wieder entfernt. Zudem dient sie im Falle von Emitter-Wrap-Through-Konfigurationen als Isolationsschicht.
■ *Strukturieren des Wafers zum Erzeugen von punkt-, linien- gitter- oder netzförmigen Durchkontaktierungen.*
   Es werden (z.B. durch Laserstrukturierung) Löcher oder Schlitze im Wafer erzeugt. Diese dienen später als punkt-, linien- gitter- oder netzförmige Durchführung der funktionellen Schicht, die auf der Vorderseite (im Betrieb lichtzugewandte Seite der Solarzelle) erzeugt wird.
■ *Ganzflächiges Texturieren und Passivieren der Vorderseite des Wafers* zur Verringerung von äußeren und inneren Reflexionen.
■ *Ganzflächiges Erzeugen der Emitterschicht oder einer Feldpassivierungsschicht auf der Vorderseite des Wafers unter Einbeziehen der Durchkontaktierungen.*
   Hierzu wird der Wafer entweder konventionell diffundiert oder es wird eine ganzflächige als Dünnschicht ausgeführt Emitter- bzw. frontseitige Feldpassivierungsschicht auf der Vorderseite des Wafers abgeschieden, die die Löcher/Schlitze füllt bzw. umrandet (z.B. a-Si:H). Die Löcher/Schlitze im Wafer werden somit Teil der funktionellen Schicht, die auf der Vorderseite der Solarzelle aufgebracht wurde.
■ *Abscheiden des einen Kontaktsystems in Form eines Kontaktgitters auf der Rückseite des Wafers unter Überdecken der Durchkontaktierungen.*
   Anschließend wird auf der elektrisch isolierenden Schutzschicht auf der Rückseite des Wafers das metallische Kontaktgitter (z.B.AI) aufgebracht. Hierbei ist zu beachten, dass sich die Löcher/Schlitzte jeweils unter den Kontaktfingern des Kontaktgitters befinden. Dies kann z.B. über Siebdruck oder über eine Metallabscheidung mit Hilfe von Schattenmasken oder Photolithographie erfolgen. Hierbei wird ein metallischer Steg an den Rand des Wafers gelegt. Im Falle einer Emitter-Wrap-Through-Konfiguration dient das Kontaktgitter zur Abführung der im Wafer (Absorberschicht) erzeugten überschüssigen Minoritätsladungsträger, die durch die Emitterschicht gesammelt werden. Im Falle einer FSF-Wrap-Through-Konfiguration dient das Kontaktgitter zur Abführung der im Wafer (Absorberschicht) erzeugten überschüssigen Majoritätsladungsträger.
■ *Erzeugen einer elektrischen, auch Durchtunneln von Ladungsträgern verhindernden Isolationsschicht auf der gesamten freien Oberfläche des Kontaktgitters.*
   Das Kontaktgitter wird dann mit einer Isolationsschicht auf seiner gesamten freien Oberfläche umgeben. Dies kann wiederum auf verschiedene Art erfolgen: Entweder über Siebdruck oder über die Abscheidung einer Isolationsschicht mit Hilfe von Schattenmasken oder Photolithographie oder über die Erzeugung eines thermischen oder elektrochemischen Metalloxids auf der Oberfläche des Kontaktgitters.
■ *Freilegen der Rückseite des Wafers ohne Beeinträchtigung der Isolationsschicht auf dem Kontaktgitter.*
   Durch selektives Ätzen (z.B. HF-Dip) wird nun der Großteil der Rückseite des Wafers, der nicht von dem Kontaktgitter bedeckt ist, durch Entfernen der elektrisch isolierenden Schutzschicht freigelegt/gereinigt, ohne dass hierbei jedoch die Isolationsschicht des Kontaktgitters entfernt wird.
■ *Ganzflächiges Abscheiden der Emitterschicht oder der Feldpassivierungsschicht, die nicht auf der Vorderseite des Wafers erzeugt worden ist, auf der Rückseite des Wafers unter deren gleichzeitiger Passivierung.*
   Auf der gesamten Rückseite des Wafers wird dann (mit Ausnahme eines Steges am Rand) die andere funktionelle Schicht (z.B. a-Si:H) ganzflächig abgeschieden. Diese bedeckt sowohl die Oberfläche des Wafers als auch die Oberfläche des Kontaktgitters und muss in der Lage sein, die freigelegte Oberfläche des Wafers gut zu passivieren.
■ *Ganzflächiges Abscheiden des anderen Kontaktsystems in Form einer Kontaktschicht auf der abgeschiedenen Emitterschicht oder Feldpassivierungsschicht auf der Rückseite des Wafers.*
   Anschließend wird die Oberfläche der anderen funktionellen Schicht (mit Ausnahme des Steges am Rand) ganzflächig metallisch kontaktiert (z.B. AI). Die metallische Kontaktschicht dient im Falle einer Emitter-Wrap-Through-Konfiguration zur Abführung der im Wafer (Absorberschicht) erzeugten überschüssigen Majoritätsladungsträger, im Falle einer frontseitige Feldpassivierungs-Wrap-Through-Konfiguration zur Abführung der im Wafer (Absorberschicht) erzeugten überschüssigen Minoritätsladungsträger, die über die Emitterschicht gesammelt werden.
■ *elektrisches Kontaktieren des Kontaktgitters und der Kontaktschicht.*
   Durch elektrische Kontaktierung des Steges (eventuell nach Entfernung der Isolationsschicht am Steg) sowie der Kontaktschicht ist die Hetero-Solarzelle dann betriebsbereit. Die beiden Kontaktsysteme (Steg des isolierten metallischen Kontaktgitters auf c-Si und ganzflächige Kontaktschicht auf a-Si:H) befinden sich auf der Rückseite der Hetero-Solarzelle und können technologisch sehr einfach im Modul rückseitig serien- oder parallelverschaltet werden. Wird der Steg des Kontaktgitters an den Rand eines quadratischen c-Si Wafers gelegt, so können der Steg des Kontaktgitters und die Kontaktschicht auf einfache Weise durch direkte Kontaktierung (z.B. mit Hilfe eines leitfähig klebenden Kupferbandes) serien- oder parallel- verschaltet werden.

### (B) Dünnschichtbasierte Hetero-Solarzellen, Substrat- und Superstrat-Konfiguration

Analoge Konzepte können auch auf dünnschichtbasierte Hetero-Solarzellen angewendet werden. Bei diesen befinden sich die beiden stromabführenden . Kontaktsysteme zweckmäßigerweise zur Vereinfachung der Prozessierung auf der Oberseite der Solarzelle. Dies entspricht einer Vorderseitenkontaktierung in der Substrat-Konfiguration und einer Rückseitenkontaktierung in der Superstrat-Konfiguration. In keinem Fall aber muss das Substrat oder Superstrat in die elektrische Kontaktierung miteinbezogen werden. Es muss daher nicht elektrisch leitend sein und kann vorteilhaft aus einfachem Glas bestehen.

Bei der Dünnschicht-Technologie werden alle Schichten vom Substrat bzw. Superstrat beginnend sequenziell abgeschieden, dieses wird im Folgenden unabhängig von seiner späteren Verwendung als Substrat oder Superstrat als unten liegend bezeichnet. Verwendete Begriffe wie Oberseite/Unterseite einer Schicht beziehen sich also auf die dem Substrat bzw. dem Superstrat weiter/näher liegende Seite, während Begriffe wie Vorderseite/Rückseite einer Schicht sich auf den Lichteinfall beziehen.

Da eine dünne Absorberschicht in der Regel nur verhältnismäßig defektreich abgeschieden werden kann, wird zweckmäßigerweise die Absorberschichtdicke so eingestellt, dass sie in der Größenordnung der Bulk-Diffusionslänge der Minoritätsladungsträger der Absorberschicht liegt. Es können dann alle in der Absorberschicht erzeugten Minoritätsladungsträger gerade noch gesammelt werden. Die Emitterschicht liegt dann zweckmäßigerweise auf der Vorderseite der Absorberschicht, da dort mehr Minoritätsladungsträger erzeugt werden, die dann durch den dort ausgebildeten p/n Übergang schneller abgeführt werden.

In der Substrat- sowie in der Superstrat-Konfiguration liegt also zweckmäßigerweise die dünne Emitterschicht auf der Vorderseite der dünnen Absorberschicht, während auf deren Rückseite eine hochleitende dünne Feldpassivierungsschicht vorliegen kann. Da im Rahmen der Dünnschicht-Technologie alle funktionellen Schichten der Solarzelle sequenziell auf dem Substrat / Superstrat abgeschieden werden, bedeutet dies, dass in der Substrat-Konfiguration zuerst die rückseitige Feldpassivierungsschicht (BSF), dann die Absorberschicht und danach die Emitterschicht abgeschieden wird, während in der Superstrat-Konfiguration entsprechend zuerst die Emitterschicht, dann die Absorberschicht und danach die rückseitige Feldpassivierungsschicht (BSF) abgeschieden wird. Die funktionelle Solarzellenschicht, die sich unterhalb der Absorberschicht befindet, wird nun durch diese durchkontaktiert, damit beide Kontaktsysteme auf der Vorderseite der Hetero-Solarzelle angeordnet werden können. Bei der durchzukontaktierenden funktionellen Schicht handelt es sich um die rückseitige Feldpassivierungsschicht (BSF) im Falle der Substrat-Konfiguration (BSF-Wrap-Through) bzw. die Emitterschicht im Falle der Superstrat-Konfiguration (Emitter-Wrap-Through).

Beispielsweise besteht eine dünnschichtbasierte Hetero-Solarzelle mit einer vorderseitigen Emitterschicht in Substrat-Konfiguration aus einer durch metallinduzierte Kristallisation erzeugten hoch dotierten poly-c-Si-Schicht als rückseitige Feldpassivierungsschicht, welche gleichzeitig als Saatschicht für die dünne Absorberschicht dient, einer aus der Gasphase epitaktisch abgeschiedenen poly-c-Si-Absorberschicht vom gleichem Dotiertyp in schwächerer Dotierung und einer aus der Gasphase amorph abgeschiedenen a-Si:H-Emitterschicht mit entgegen gesetzter Dotierung. Analog besteht beispielsweise eine dünnschichtbasierte Hetero-Solarzelle mit einer vorderseitigen Emitterschicht in Superstrat-Konfiguration aus einer durch metallinduzierte Kristallisation erzeugten hoch dotierten poly-c-Si-Schicht als Emitterschicht, welche gleichzeitig als Saatschicht für die Absorberschicht dient, einer aus der Gasphase epitaktisch abgeschiedenen poly-c-Si-Absorberschicht mit entgegen gesetzter Dotierung und einer aus der Gasphase amorph abgeschiedenen a-Si:H rückseitigen Feldpassivierungsschicht vom gleichem Dotiertyp wie die Absorberschicht.

Prinzipiell kann die Emitterschicht auch auf der Rückseite der Solarzelle angeordnet sein. Diese Anordnung ist allerdings nur dann sinnvoll, wenn die Schichtdicke der Absorberschicht so dünn gewählt werden kann, dass sie wesentlich kleiner als die Bulk-Diffusionslänge der Minoritätsladungsträger in der Absorberschicht ist. Nur dann ist sichergestellt, dass die hauptsächlich in der vorderseitigen Absorberschicht erzeugten Minoritätsladungsträger auch ohne nennenswerte Rekombinationsverluste die Emitterschicht erreichen. Bei gleichzeitiger Forderung einer hinreichend hohen Absorptivität der Absorberschicht erfordert dies die Abscheidung einer sehr defektarmen Absorberschicht. Ist dies gegeben und ist die Grenzflächen-Passivierung der Feldpassivierungsschicht besser als die der Emitterschicht (was häufig der Fall ist, da diese speziell darauf optimiert werden kann), so ist die rückseitige Anordnung der Emitterschicht vorteilhaft, da die Passivierung der Vorderseite der Hetero-Solarzelle bedeutender ist als die der Rückseite.

Da im Rahmen der Dünnschicht-Technologie alle funktionellen Schichten der Solarzelle sequenziell auf dem Substrat bzw. Superstrat abgeschieden werden, bedeutet dies, dass in der Substrat-Konfiguration zuerst die Emitterschicht, dann die Absorberschicht und danach die frontseitige Feldpassivierungsschicht (FSF), während in der Superstrat-Konfiguration entsprechend zuerst die frontseitige Feldpassivierungsschicht (FSF), dann die Absorberschicht und danach die Emitterschicht abgeschieden werden. Die funktionelle Solarzellenschicht, die sich unterhalb der Absorberschicht befindet, soll nun wiederum durch diese durchkontaktiert werden, damit beide Kontaktsysteme auf der Solarzellenoberseite angeordnet werden können. Dies ist also die Emitterschicht im Falle der Substrat-Konfiguration (Emitter-Wrap-Through) bzw. die frontseitige Feldpassivierungsschicht (FSF) im Falle der Superstrat-Konfiguration (FSF-Wrap-Through).

Beispielsweise besteht eine dünnschichtbasierte Hetero-Solarzelle mit rückseitiger Emitterschicht in Substrat-Konfiguration aus einer durch metallinduzierte Kristallisation erzeugten hoch dotierten poly-c-Si Schicht als Emitterschicht, welche gleichzeitig als Saatschicht für die dünne Absorberschicht dient, einer aus der Gasphase epitaktisch abgeschiedenen poly-c-Si-Absorberschicht mit entgegen gesetzter Dotierung und einer aus der Gasphase amorph abgeschiedenen a-Si:H frontseitigen Feldpassivierungsschicht (FSF) vom selben Dotiertyp wie die Absorberschicht. Analog besteht beispielsweise eine dünnschichtbasierte Hetero-Solarzelle mit rückseitiger Emitterschicht in der Superstrat-Konfiguration aus einer durch metallinduzierte Kristallisation erzeugten hoch dotierten poly-c-Si-Schicht als frontseitige Feldpassivierungsschicht (FSF), welche gleichzeitig als Saatschicht für die dünne Absorberschicht dient, einer aus der Gasphase epitaktisch abgeschiedenen poly-c-Si-Absorberschicht vom gleichem Dotiertyp in schwächerer Dotierung und einer aus der Gasphase amorph abgeschiedenen a-Si:H-Emitterschicht mit entgegen gesetzter Dotierung. Die funktionelle Solarzellenschicht, die sich unterhalb der Absorberschicht befindet und damit näher am Substrat/Superstat liegt, kann nun durch in der Absorberschicht vorgesehene Durchgangsöffnungen an die Vorderseite der Absorberschicht, die weiter entfernt vom Substrat/ Superstrat liegt, durchkontaktiert werden. Die Ladungsträger der Absorberschicht, die von der entsprechenden funktionellen Schicht gesammelt werden, werden nun auf der Vorderseite der Absorberschicht über das isolierend bedeckte metallische Kontaktgitter gesammelt. Hierbei ist zu beachten, dass die Finger des Kontaktgitters jeweils die Durchgangsöffnungen in der Absorberschicht abdecken. Das Kontaktgitter ist dabei in der zweiten (ganzflächig abscheidbaren) funktionalen Solarzellenschicht integriert. Beide Kontaktsysteme befinden sich auf der Oberseite der Solarzelle. Dabei beschränkt sich die Strukturierung der Absorberschicht auf das einfache Erzeugen von Durchgangsöffnungen (Löcher oder Schlitze). Beide funktionelle Solarzellenschichten (Emitter- und Feldpassivierungsschicht) können vorteilhaft ganzflächig abgeschieden werden. Ein bevorzugtes Herstellungsverfahren für eine derartige dünnschichtbasierte Solarzelle und vorteilhafte Modifikationen können folgendermaßen aussehen:
■ *Aufbringen der Emitterschicht oder einer Feldpassivierungsschicht und der Absorberschicht auf einem Substrat oder Superstrat.*
   Auf einem Substrat/Superstrat (z.B. Glas) wird via Dünnfilm-Technologie ein Schichtenpaket aus einer ersten funktionellen Schicht und einer dünnen Absorberschicht aufgebracht. Dies ist je nach erwünschter Konfiguration der dünnschichtbasierten Solarzelle entweder das Schichtenpaket Emitterschicht/ Absorberschicht oder das Schichtenpaket Feldpassivierungsschicht/ Absorberschicht (z.B. das Schichtenpaket hochdotierte poly-c-Si Saatschicht auf Glas / niederdotierte epitaktisch abgeschiedene poly-c-Si Absorberschicht). Hierzu werden eventuell noch eine oder mehrere funktionelle Schichten als Zwischenschichten (zwischen dem Substrat/Superstrat und der ersten funktionellen Schicht) benötigt, die als Puffer-/Reflexions-/Saat- oder Passivierungs-Schichten dienen, um die Effizienz der Solarzelle zu erhöhen. Es können beispielsweise Pufferschichten in geringstmöglicher Schichtdicke zwischen der Emitter- und der Absorberschicht eingesetzt werden, um die Grenzfläche zwischen Emitter und Absorber besser zu passivieren. Im Fall von dotierten amorphem Silizium als Emittermaterial auf einem kristallinen Silizium-Wafer als Absorberschicht kann die Pufferschicht beispielsweise als ultradünne (ca. 5 nm) Schicht aus intrinsischen (undotiertem) amorphem Silizium bestehen. Pufferschichten können aber auch von einem Salz, beispielsweise aus Cäsiumchlorid, gebildet werden. Es wird dann ein entsprechender Oberflächendipol aufgespannt und ebenfalls die Grenzflächen-Rekombination am pn-Übergang unterdrückt. Zudem kann bei Bedarf die Oberfläche der Absorberschicht texturiert werden.
   Die Schichtstärke der Emitterschicht ist immer so bemessen, dass die Ladungsträger der Absorberschicht auf die absorberschichtabgewandte Rückseite der Emitterschicht gelangen können. Weiterhin kann die Emitterschicht aus einem solchen Material bestehen, dass zur Absorberschicht ein gut passivierender pn-Übergang aufgespannt wird, wobei eine maximale Grenzflächen-Rekombinationsrate der Ladungsträger von 10⁵ Rekombinationen/cm²s einzuhalten ist. Anzustreben ist aber eine Grenzflächen-Rekombinationsrate von beispielsweise 10² Rekombinationen/cm²s.
■ *Strukturieren der Absorberschicht mit einfachen Durchgangsöffnungen zum Erzeugen von punkt-, linien- gitter- oder netzförmigen Durchkontaktierungen der Emitterschicht oder Feldpassivierungsschicht durch die Absorberschicht.*
   Es werden (z.B. durch Laserstrukturierung oder durch selektives Ätzen) Löcher oder Schlitze in der Absorberschicht erzeugt. Diese dienen später als punkt-, linien- gitter- oder netzförmige Durchführung der ersten funktionellen Schicht, die unterhalb der Absorberschicht abgeschieden wurde. Im Falle einer Emitter-Wrap-Through-Konfiguration muss vorher noch eine ganzflächige Isolationsschicht (z.B. ein ganzflächig abgeschiedenes PECVD-Oxid) auf der Oberfläche der Absorberschicht erzeugt werden. Im Falle einer BSF- oder FSF-Wrap-Through- Konfiguration ist dies optional.
   Alternativ kann im Falle einer metallischen Durchkontaktierung in der BSF-oder FSF-Wrap-Through-Konfiguration auch die vorhergehende Strukturierung der Absorberschicht entfallen, wenn z.B. über thermische Verdampfung ein metallisches Kontaktgitter oder metallische Punktkontakte (z.B. AI) auf der Oberfläche der Absorberschicht aufgebracht werden und das Dünnschichtpaket anschließend getempert wird. Hierdurch kann das Metall aufgrund einer bevorzugten Spikebildung in die Absorberschicht eingetrieben werden (z.B. speziell das System Al auf Si), sodass das Metall zur rück- bzw. frontseitigen Feldpassivierungsschicht durchkontaktiert. Dieser Verfahrensschritt kann dann ebenfalls parallel mit dem Aufbringen des Kontaktgitters auf einer Seite der Absorberschicht erfolgen.
■ *Befüllen der Durchgangsöffnungen mit einem funktionellen Schichtmaterial oder einem elektrisch leitenden Material.*
   Die erzeugten Durchgangsöffnungen (Löcher/Schlitze) in der Absorberschicht werden nun entweder mit einem Funktionsmaterial, das der Funktion der zweiten funktionellen Solarzellenschicht entspricht, oder mit einem leitenden Material gefüllt. Hierbei ist zu beachten, dass bei der Befüllung mit einem leitenden Material dieses im Falle der Emitter-Wrap-Through-Konfiguration gegenüber der Absorberschicht elektrisch isoliert sein muss, d.h. in diesem Falle müssen die Durchgangsöffnungen erst mit einer einem isolierenden Material inwendig beschichtet und anschließend mit einem leitfähigen Material befüllt werden. Im Falle einer BSF- oder FSF-Wrap-Through-Konfiguration ist dies optional. Im Falle der Befüllung mit einem metallischen Material kann dieser Verfahrensschritt auch zeitgleich (parallel) mit dem Verfahrensschritt des Aufbringen des Kontaktgitters ausgeführt werden, indem (z.B. über Siebdruck) eine metallische Paste aufgetragen wird, die dann die die Durchgangsöffnungen mit befüllt.
■ *Abscheiden des einen Kontaktsystems in Form eines Kontaktgitters auf der der Emitterschicht oder Feldpassivierungsschicht gegenüberliegenden Seite der Absorberschicht.*
   Anschließend wird auf der Oberseite der Absorberschicht das metallische Kontaktgitter (z.B. Al) aufgebracht. Im Falle einer Emitter-Wrap-Through-Konfiguration muss dies auf der elektrisch isolierenden Schutzschicht, die entsprechend zuvor auf der der Feldpassivierungsschicht zugewandten Seite der Absorberschicht erzeugt wurde, geschehen, im Falle einer BSF- oder FSF-Wrap-Through-Konfiguration ist dies optional. Beim Aufbringen des Kontaktgitters ist zu beachten, dass sich die Durchgangsöffnungen in der Absorberschicht jeweils unter den Fingern des Kontaktgitters befinden. Im Falle einer Emitter-Wrap-Through-Konfiguration dient das Kontaktgitter zur Abführung der in der Absorberschicht erzeugten Überschuss-Minoritätsladungsträger, die durch die Emitterschicht gesammelt werden. Im Falle einer FSF-Wrap-Through-Konfiguration dient das Kontaktgitter zur Abführung der in der Absorberschicht erzeugten Überschuss-Majoritätsladungsträger. Ist das Kontaktgitter auf der Vorderseite der Absorberschicht angeordnet, ist dessen Kontaktfläche zur Absorberschicht so bemessen, dass es den zu erwartenden Strom optimal abführen kann, die Abschattungsfläche aber trotzdem minimal ist. Die Gesamtfläche des Kontaktgitters beträgt dazu in der Regel weniger als 5% der Absorberfläche.
   Das Aufbringen des Kontaktgitters - wobei unter dem Begriff "Gitter" auch jede fingerförmige oder netzartige oder ähnliche schmalstegige Ausprägung auch ohne Kreuzungen verstanden werden soll - kann in vorgefertigter Form direkt auf die Absorberschicht beispielsweise mittels eines Leitklebers erfolgen. Weiterhin kann das Kontaktgitter selektiv direkt auf der Absorberschicht durch einfachen Siebdruck oder unter Anwendung einer entsprechenden Maske durch thermisches Verdampfen eines elektrisch leitfähigen Materials oder über eine Metallabscheidung mit Hilfe von Schattenmasken oder Photolithographie erfolgen. Anwendung von Tintenstrahldruck oder Photolithographie ist ebenfalls möglich.
■ *Erzeugen einer elektrischen, auch Durchtunneln von Ladungsträgern verhindernden Isolationsschicht (IS) auf der gesamten freien Oberfläche des Kontaktgitters (KG.*
   Das Kontaktgitter wird dann mit einer Isolationsschicht ummantelt. Dies kann wiederum auf verschiedene Art erfolgen: Entweder über Siebdruck oder über die Abscheidung einer Isolatorschicht mit Hilfe von Schattenmasken oder Photolithographie oder über die Erzeugung eines thermischen oder elektrochemischen Metalloxids auf der Oberfläche des Kontaktgitters. Dabei weist diese Isolationsschicht mindestens eine solche minimale Schichtstärke auf, dass auch das Durchtunneln von Ladungsträgern sicher verhindert ist.
   Zum Aufbringen der Isolationsschicht auf die gesamte freie Oberfläche des Kontaktgitters kann beispielsweise eine isolierende Masse selektiv unter Anwendung von Sieb- oder Tintenstrahldruck oder einer Maske, insbesondere einer Schattenmaske, Sputtern, Gasphasenabscheidung oder Photolithographie aufgebracht werden. Alternativ kann auch auf der gesamten freien Oberfläche von Kontaktgitter und der dazwischen freiliegenden Absorberschicht thermisch oder nasschemisch oder elektrochemisch eine elektrisch isolierende Schutzschicht aufgewachsen werden. Hierbei bildet sich aufgrund der für Kontaktgitter und Absorberschicht unterschiedlich gewählten Materialien auch eine unterschiedliche Schutzschicht aus. Bei einem Kontaktgitter beispielsweise aus Aluminium entsprechend Aluminiumoxid, bei einer Absorberschicht aus Silizium im Falle einer Sauerstoff-Temperung thermisches Siliziumoxid. Im Beispiel einer Sauerstoff-Temperung kann bei einem Aluminium-Kontaktgitter auf einer Silizium-Absorberschicht ein ca. 20 nm dickes Aluminiumoxid an der gesamten freien Oberfläche des Kontaktgitters und ein ca. 5 nm dickes Siliziumoxid auf der nicht vom Kontaktgitter bedeckten Absorberschicht erwartet werden. Im Falle der thermischen Erzeugung der Schutzschicht kann dieser Vorgang zusammen mit dem Eintempern des leitenden Materials des Kontaktgitters in die Absorberschicht zur Bildung eines BSF in einem temperaturgesteuerten Heizprozess durchgeführt werden.
■ *Freilegen der der Emitterschicht oder Feldpassivierungsschicht gegenüberliegenden Seite der Absorberschicht ohne Beeinträchtigung der Isolationsschicht auf dem Kontaktgitter.*
   Durch selektives Ätzen/Reinigen (z.B. HF-Dip) wird nun der Großteil der Oberfläche der Absorberschicht, die nicht von dem Kontaktgitter bedeckt ist, freigelegt, ohne dass hierbei die Isolationsschicht des Kontaktgitters entfernt wird. Dies entspricht einem Entfernen der elektrisch isolierenden Schutzschicht (z.B. thermisches Oxid) im Falle einer Emitterschicht-Durchkontaktierung bzw. einem Reinigen (= Entfernen des natürlichen Oxids) der freiliegenden Oberfläche der Absorberschicht.
   Das selektive Ätzen der Schutzschicht (bevorzugt Oxidschicht) auf der Absorberschicht ist entsprechend problemlos durchzuführen, da die unterschiedlichen Oxide in der Regel unterschiedliche Ätzraten im Ätzprozess aufweisen. Insbesondere ist, bei einem entsprechend gewählten Ätzmedium, ein Metalloxid ätzresistenter als ein Siliziumoxid. Im Materialbeispiel von Aluminium und Silizium, das dann entsprechend auch für die Emitterschicht verwendet wird, kann das selektive Ätzen beispielsweise durch einfaches kurzzeitiges Eintauchen in verdünnte Flusssäure HF umgesetzt werden. Die Flusssäure entfernt hierbei nicht nur selektiv das Silizium-Oxid, sondern gewährleistet gleichzeitig eine gute Oberflächenpassivierung der Absorberschicht aus Silizium durch Ausbildung von Si-H-Bindungen. Das Ätzmittel kann also so gewählt werden, dass nach der Entfernung des Oxids auf der Absorberschicht diese an ihrer freigelegten Oberfläche gut passiviert wird.
■ *ganzflächiges Abscheiden der noch nicht abgeschiedenen Emitter-schicht oder der Feldpassivierungsschicht auf der Seite der Absorberschicht mit dem Kontaktgitter unter gleichzeitiger Passivierung der freigelegten Bereiche der Absorberschicht.*
   Auf der gesamten Seite der Absorberschicht mit dem Kontaktgitter wird dann (mit Ausnahme eines kleinen Bereichs des Kontaktgitters, der für die spätere Kontaktierung benötigt wird) die zweite funktionelle Solarzellenschicht (z.B. a-Si:H) ganzflächig abgeschieden. Dies ist je nach erwünschter Solarzellen-Konfiguration, dann die Emitterschicht oder die frontseitig e oder die rückseitige Feldpassivierungsschicht (FSF, BSF). Diese bedeckt dann vollständig sowohl die freie Oberfläche der Absorberschicht als auch (vollständig oder teilweise) die Oberfläche des isolierten Kontaktgitters Die abgeschiedene zweite funktionale Schicht muss in der Lage sein, die freigelegte Oberfläche der Absorberschicht (Grenzfläche) gut zu passivieren.
■ *ganzflächiges Abscheiden des anderen Kontaktsystems in Form einer Kontaktschicht auf der abgeschiedenen Emitterschicht oder Feldpassivierungsschicht auf der Seite der Absorberschicht mit dem. Kontaktgitter.*
   Anschließend wird die freie Seite der zweiten abgeschiedenen funktionalen Schicht ganzflächig metallisch kontaktiert (z.B. AI oder TCO), sodass ein guter ohmscher Kontakt entsteht. Die metallische Kontaktschicht dient im Falle einer Emitter-Wrap-Through-Konfiguration zur Abführung der in der Absorberschicht erzeugten Überschuss-Majoritätsladungsträger, im Falle einer FSF-Wrap-Through-Konfiguration zur Abführung der in der Absorberschicht erzeugten Überschuss-Minoritätsladungsträger, die über die Emitterschicht gesammelt werden. Dabei kann die Kontaktschicht ganzflächig oder durch Anwendung von Maskentechnik teilflächig ausgebildet sein und in einfacher Weise, beispielsweise durch Applizieren eines Metallkontaktes oder durch Aufdampfen, aufgebracht werden.
■ *elektrisches Kontaktieren des Kontaktgitters und der Kontaktschicht.*
   Durch elektrische Kontaktierung des ausgesparten Bereichs des Kontaktgitters (eventuell nach der Entfernung der Isolationsschicht) sowie der Kontaktschicht ist die Solarzelle dann betriebsbereit. Die beiden Kontaktsysteme (Kontaktgitter und Kontaktschicht) befinden sich auf der Vorderseite der Solarzelle, d.h. auf der für den Lichteinfall vorgesehenen Seite der Solarzelle im späteren Betriebsfall. Die elektrische Kontaktierung des Kontaktgitters kann durch seitlich angeordnete Stege oder durch Aussparen (beispielsweise per Schattenmaske) eines Anschlussbereiches auf dem Kontaktgitter während der Schichtabscheidung und Freilegen des Anschlussbereiches durch Entfernen (beispielsweise durch mechanisches Abkratzen) der vorhergehend erzeugten Isolationsschicht erfolgen. Das elektrische Kontaktieren der Kontaktschicht kann aufgrund ihrer direkten Zugänglichkeit ohne weitere Maßnahmen direkt erfolgen. Eine Modulverschaltung kann in einfacher Weise wie nachfolgend beschrieben erfolgen.

Bei der Dünnschicht-Solarzellen-Technologie mit einer Abscheidungsmöglichkeit auf einem großflächigem Substrat oder Superstrat, z.B. Glas, wird üblicherweise gleich ein gesamtes Solarzellen-Modul gefertigt. Hierzu werden nach der Abscheidung der funktionellen Solarzellenschichten einzelne Bereiche (in der Regel Streifen) auf dem Substrat oder Superstrat durch Strukturierung erzeugt, die dann als einzelne Solarzellen funktionieren und entsprechend serien- und/oder parallel- verschaltet werden. Die dünnschichtbasierte Hetero-Solarzellenstruktur nach der Erfindung erlaubt eine einfache Serien- und Parallel-Verschaltung der einzelnen Solarzellen-Bereiche, die mit nur zwei Strukturierungsschritten auskommt, wobei alle Solarzellen-Schichten weiterhin ganzflächig abgeschieden werden können. Nähere Ausführungen hierzu sind dem speziellen Beschreibungsteil zu entnehmen.

Das Verfahren nach der Erfindung eignet sich in gleicher Weise zur Herstellung einer einseitigen Vorderseiten- oder Rückseitenkontaktierung der Solarzelle. Dabei hängt die Wahl der einseitigen Kontaktierung von der elektronischen Qualität der Absorberschicht und der gewünschten Substrat- bzw. Superstrat-Konfiguration ab. Ist die Absorberqualität gut, so kann die Emitterschicht auf die Rückseite der Absorberschicht gelegt werden. Ist die Absorberqualität jedoch schlecht, so sollte die Emitterschicht auf die Vorderseite der Absorberschicht gelegt werden. Dies entspricht jeweils einer Vorderseitenkontaktierung im Falle der Substrat-Konfiguration und einer Rückseitenkontaktierung im Falle der Superstrat-Konfiguration. Bei einer Vorderseitenkontaktierung ist die Kontaktschicht transparent auszuführen, beispielsweise in Form einer transparenten leitenden Oxidschicht, TCO. Zur Verbesserung der Ladungsträgersammlung auf der Vorderseite der Absorberschicht können dann noch stromsammelnde Kontaktelemente vorgesehen sein. Damit die Abschattungsverluste minimiert werden, ist es vorteilhaft, wenn Kontaktelemente und Kontaktgitter kongruent aufgebaut sind und direkt übereinander positioniert werden.

Absorber-, Emitter- und Feldpassivierungsschichten können bevorzugt aus Silizium bestehen. Dabei kann kristallines Silizium, insbesondere mit n- oder p-typ Dotierung (n/p c-Si), für die Absorberschicht und amorphes, mit Wasserstoff angereichertes Silizium, entsprechend mit p- oder n-typ Dotierung (p/n aSi:H), für die Emitterschicht eingesetzt werden. Eine optional vorhandene Pufferschicht zwischen Absorber- und Emitterschicht kann ebenfalls bevorzugt aus amorphem Silizium, allerdings undotiert, bestehen. Ein derartiges Material-system gewährleistet einen besonders gut passivierten pn-Übergang zur Ladungstrennung. Alle Kontaktsysteme und Kontaktelemente können bei einer Rückseitenkontaktierung aus Aluminium bestehen. Bei einer Vorderseitenkontaktierung muss die Kontaktschicht aus einem transparenten Leitmaterial, beispielsweise ZnO, bestehen. Substrate und Superstrate sind bevorzugt aus elektrisch nicht leitendem Glas. Die Feldpassivierungsschicht kann auf der Vorderseite der Absorberschicht aus einem polykristallinen Silizium und auf der Rückseite aus einem amorphen, mit Wasserstoff angereichertem Silizium bestehen. Zur Herstellung der Durchkontaktierungen kann Emitter- oder Feldpassivierungsschichtmaterial, aber auch anderes elektrisch leitfähiges Material, beispielsweise ein Polymer oder ein Metall, eingesetzt werden. Als isolierendes Material für das Kontaktgitter und die Durchgangsöffnungen eignet sich beispielsweise ein Oxid. Für eine Passivierungsschicht, die gleichzeitig auch als Feldpassivierungsschicht arbeitet, kann beispielsweise SiN eingesetzt werden.

### Ausführungsbeispiele

Die einseitig kontaktierte Solarzelle nach der Erfindung in ihren verschiedenen Ausführungsformen wird nachfolgend anhand von Ausführungsbeispielen in den schematischen, nicht maßstabsgerechten Figuren näher erläutert. Dabei zeigen die dargestellten Solarzellen folgende Ausführungsformen:
- **Figuren 1A...D**: Waferbasis, Rückseitenkontaktierung, Emitter-Wrap-Through-Konzept
- **Figuren 2A,2B**: Waferbasis, Rückseitenkontaktierung, FSF-Wrap-Through-Konzept
- **Figur 3**: Waferbasis, Rückseitenkontaktierung, Serien- und Parallelverschaltung
- **Figuren 4A,4B**: Dünnschichtbasis, Emitterschicht auf Vorderseite, Substrat-Konfiguration, BSF-Wrap-Through-Konzept I
- **Figuren 5A,5B**: Dünnschichtbasis, Emitterschicht auf Vorderseite, Substrat-Konfiguration, BSF-Wrap-Through-Konzept II
- **Figuren 6A,6B**: Dünnschichtbasis, Emitterschicht auf Vorderseite, Superstrat-Konfiguration, Emitter-Wrap-Through-Konzept I
- **Figuren 7A,7B**: Dünnschichtbasis, Emitterschicht auf Vorderseite, Superstrat-Konfiguration, Emitter-Wrap-Through-Konzept II
- **Figuren 8A,8B**: Dünnschichtbasis, Emitterschicht auf Rückseite, Substrat-Konfiguration, Emitter-Wrap-Through-Konzept I
- **Figuren 9A,9B**: Dünnschichtbasis, Emitterschicht auf Rückseite, Substrat-Konfiguration, Emitter-Wrap-Through-Konzept II
- **Figuren 10A,10B**: Dünnschichtbasis, Emitterschicht auf Rückseite, Superstrat-Konfiguration, FSF-Wrap-Through-Konzept I
- **Figuren 11A,11B**: Dünnschichtbasis, Emitterschicht auf Rückseite, Superstrat-Konfiguration, FSF-Wrap-Through-Konzept II
- **Figuren 12A,12B**: Dünnschichtbasis, Serienverschaltung und
- **Figuren 13A,13B**: Dünnschichtbasis, Parallelverschaltung

### Waferbasierte Hetero-Solarzelle mit Rückseitenkontaktierung und Emitterschicht-Durchkontaktierung (Emitter-Wrap-Through-Konzept)

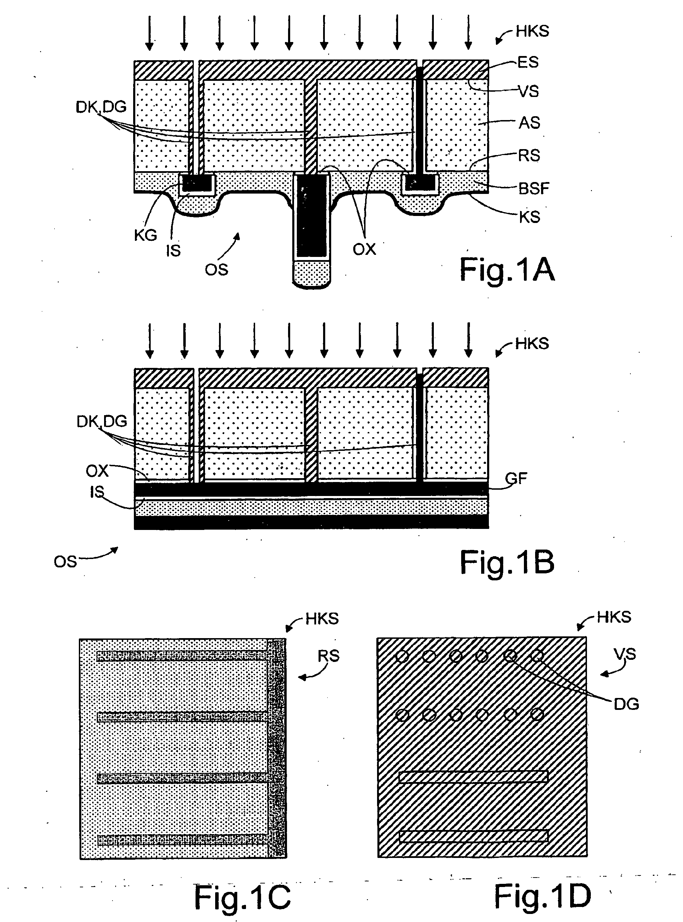

In der **Figur 1A** ist ein Querschnitt einer Solarzelle **HKS** (hier in der Ausführung einer Heterokontakt-Solarzelle; durch entsprechende Materialwahl von Absorber- und Emitterschicht ist aber auch eine Homokontakt-Solarzelle analog konzipierbar) mit einer waferbasierten Absorberschicht **AS** (c-Si), einer Emitterschicht **ES** (diffundiert oder a-Si:H) auf der Vorderseite **VS** (im Betriebsfall lichtzugewandte Seite, Lichteinfall durch parallele Pfeile dargestellt) der Absorberschicht **AS** und einer Feldpassivierungsschicht **BSF** (beispielsweise a-Si:H) dargestellt. Weiterhin weist die Solarzelle **HKS** Durchkontaktierungen **DK** mit punktförmigen Durchgangsöffnungen **DG** in drei verschiedenen Ausführungsformen auf (links diffundiert/c-Si, mitte befüllt a-Si:H, rechts isoliert und metallisch befüllt/AI). Dabei handelt es sich um eine schematische Zusammenstellung der verschiedenen Durchkontaktierungsmöglichkeiten. In der Praxis wird jeweils nur eine Möglichkeit durchgängig ausgeführt (gilt auch für nachfolgend dargestellte unterschiedliche Durchkontaktierungen). Außerhalb der punktförmigen Durchkontaktierungen **DK** ist die Absorberschicht **AS** mit einer isolierenden Schutzschicht **OX** zur Vermeidung von Kurzschlüssen mit dem mit der Emitterschicht **ES** verbundenen Kontaktgitter **KG** überzogen. Gezeigt ist außerdem, dass die Feldpassivierungsschicht **BSF** (oder analog die Emitterschicht **ES)** das Kontaktgitter **KG** mit einer geschlossenen Oberfläche überdecken kann (links, rechts). Ist das Kontaktgitter **KG** mit seiner Isolationsschicht **IS** jedoch dicker als die Schichtstärke der Feldpassivierungsschicht **BSF** (oder der Emitterschicht **ES),** kann diese im Bereich des Kontaktgitters **KG** auch unterbrochen sein (mitte). Es kann sich dann auch eine Unterbrechung der Kontaktschicht **KS** ergeben. Bei der Unterbrechung handelt es sich dann aber nicht um eine aufwändige Strukturierung, sondern um eine sich von selbst einstellende Anordnung. Alle in den weiteren Figuren nicht angezeigte oder erläuterte Bezugszeichen sind der **Figur 1** zu entnehmen.

Die **Figur 1B** zeigt einen Längsschnitt der Solarzelle **HKS** gemäß **Figur 1A** durch einen Gitterfinger **GF** des Kontaktgitters **KG** mit den drei unterschiedlichen Durchkontaktierungen **DK.** Die **Figur 1C** zeigt eine Aufsicht auf die Solarzelle HKS gemäß **Figur 1A** von der Rückseite **RS** (im Betriebsfall lichtabgewandte Seite, Lichteinfall durch parallele Pfeile dargestellt) und die **Figur 1D** eine Aufsicht von der Vorderseite **VS.** Gezeigt sind Durchgangsöffnungen **DG** in Form von Löchern (punktförmig, oben) und Schlitzen (linienförmig, unten).

### Waferbasierte Solarzelle mit Rückseitenkontaktierung und frontseitiger Feldpassivierungsschicht -Durchkontaktierung (FSF-Wrap-Through-Konzept)

Wird die Emitterschicht **ES** auf der Rückseite **RS** der Absorberschicht **AS** positioniert, kann in analoger Weise eine frontseitige Passivierungsschicht (chemisch), wenn sie zusätzlich als frontseitige Feldpassivierungsschicht **FSF**(elektronisch, z.B. a-Si:H) ausgeführt ist, durch Durchgangsöffnungen DG in der Absorberschicht **AS** punktuell auch auf die Rückseite **RS** führen. Das hiermit neu definierte **"FSF**-Wrap-Through"-Konzept entspricht dem "Metal-Wrap-Through"-Konzept für rückseitenkontaktierte Solarzellen, wobei anstelle eines Metalls die frontseitige Feldpassivierungsschicht **FSF** durchgeführt wird. Diese besteht aus einem elektrisch leitfähigen Material, beispielsweise einem Polymer, einem Metall oder einem Halbleiter (beispielsweise a-Si:H). Hierdurch können ohmsche Verluste der Ladungsträger, die nun unter der Voraussetzung, dass die durchkontaktierte Feldpassivierungsschicht **FSF** besser leitet als die Absorberschicht **AS,** nicht mehr durch die Absorberschicht **AS**, sondern durch die Feldpassivierungsschicht **FSF** zu dem Kontaktgitter **KG** fließen, minimiert werden. Der Serienwiderstand und somit der Füllfaktor einer rückseitenkontaktierten Solarzelle **HKS** mit auf der Rückseite **RS** angeordneter Emitterschicht **ES** lässt sich hierdurch verbessern.

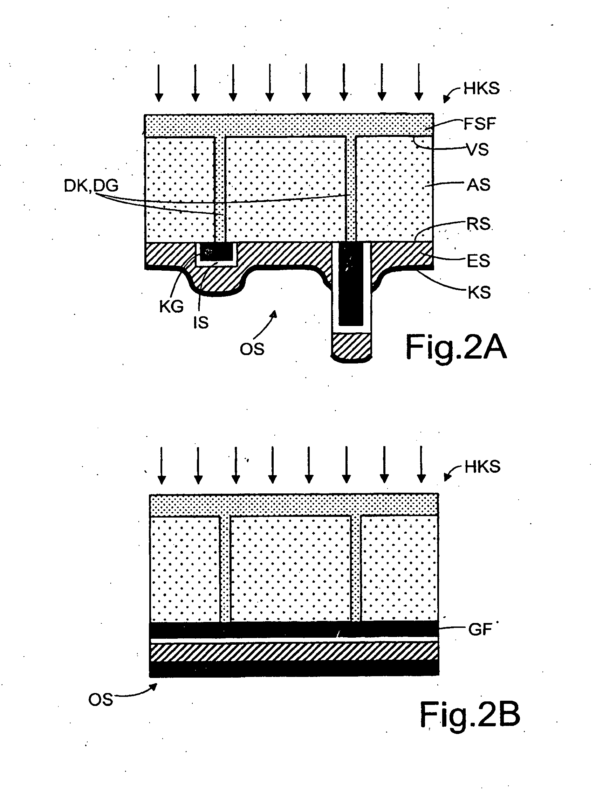

In der **Figur 2A** ist im Querschnitt eine Solarzelle **HKS** mit einer waferbasierten Absorberschicht **AS,** einer zum Kontaktgitter **KG** durch die Absorberschicht **AS** hindurch durchkontaktierten Feldpassivierungsschicht **FSF** und einer auf der Rückseite der Absorberschicht **AS** angeordnete Emitterschicht **ES** dargestellt. Die Durchkontaktierung **DK** erfolgt wiederum durch gefüllte, beschichtete oder diffundierte Durchgangsöffnungen **DG.** Das Kontaktgitter **KG** ist mit der Absorberschicht **AS** und zusätzlich mit der Feldpassivierungsschicht **FSF** elektrisch leitend verbunden. Die **Figur 2B** zeigt wiederum einen Längsschnitt durch einen Gitterfinger **GF** des Kontaktgitters **KG.** Eine Isolation der Absorberschicht **AS** gegenüber dem Kontaktgitter **KG** ist bei einer Durchkontaktierung einer Feldpassivierungsschicht **FSF, BSF** nicht erforderlich. Das Kontaktgitter **KG** sammelt dann aus beiden funktionellen Schichten die überschüssigen Ladungsträger ein.

### Waferbasierte Solarzelle mit Rückseitenkontaktierung mit Serien- und Parallelverschaltung

Die **Figur 3** zeigt eine Aufsicht auf die Rückseite eines Solarzellenmoduls **SZM** mit Serienverschaltung **SV** und Parallelverschaltung **PV** von Solarzellen HKS. Zu erkennen sind das fingerförmige Kontaktgitter **KG** mit den seitlichen Stegen **ST** und die waferbasierte Absorberschicht **AS.** Die ganzflächige rückseitige Kontaktschicht **KS** ist nicht dargestellt. Die parallelverschalteten Stege **ST** sind durch Kupferband KB miteinander in Serie verschaltet.

### Dünnschichtbasierte Solarzelle mit frontseitiger Emitterschicht in Substrat-Konfiguration und rückseitiger Feldpassivierungsschicht -Durchkontaktierung (BSF-Wrap-Through-Konzepte I, II)

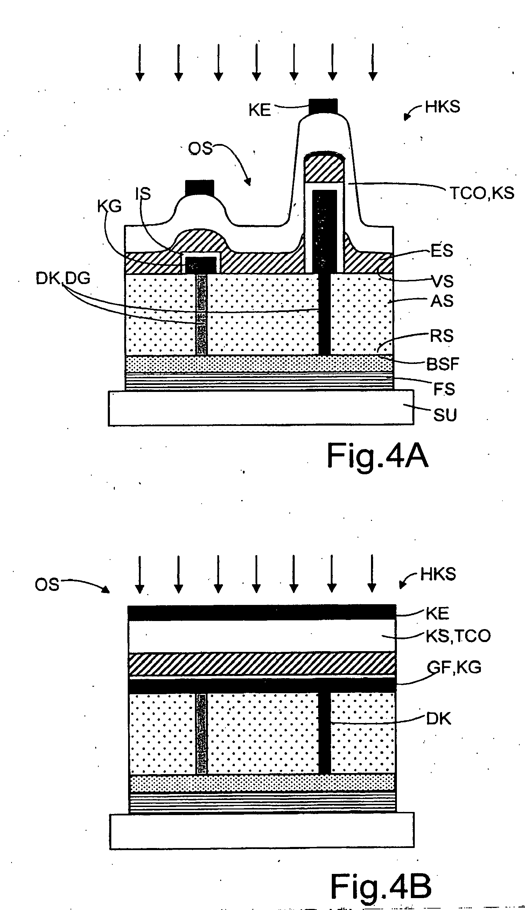

In der **Figur 4A** ist im Querschnitt eine Solarzelle **HKS** (hier in der Ausführung einer Heterokontakt-Solarzelle; durch entsprechende Materialwahl von Absorber- und Emitterschicht ist aber auch eine Homokontakt-Solarzelle analog konzipierbar) in Substrat-Konfiguration mit einer dünnen Absorberschicht **AS,** einer auf der lichtzugewandten Vorderseite der Absorberschicht **AS** angeordneten Emitterschicht **ES,** einer zum Kontaktgitter **KG** durch die Absorberschicht **AS** hindurch durchkontaktierten rückseitigen Feldpassivierungsschicht **BSF** (BSF-Wrap-Through-Konzept I), einer zwischengelagerten funktionellen Schicht **FS** und einem Substrat **SU** dargestellt. Eine Oberseite **OS** ist definiert als die dem Substrat **SU** gegenüberliegende Seite der Solarzelle **HKS.** Die Finger des Kontaktgitters **KG** sind in unterschiedlichlier Höhe dargestellt. Die Durchkontaktierung **DK** basiert auf mit leitfähigem Material (Polymer, Metall, a-Si:H) gefüllten Durchgangsöffnungen **D.G**. Die ganzflächige Kontaktschicht **KS** ist als transparente leitfähige Oxidschicht **TCO** ausgeführt, auf der ein stromsammelndes Kontaktelement **KE** aufweist.

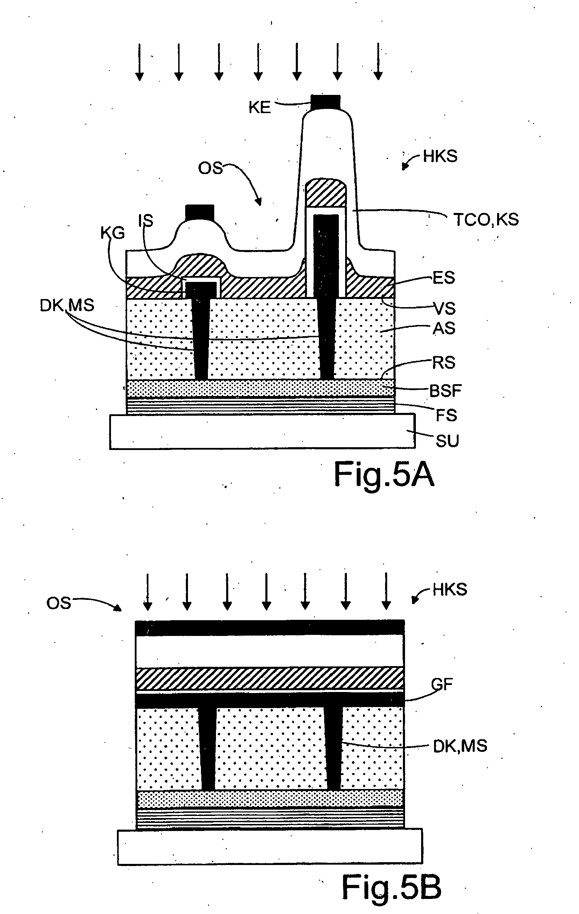

Die Figur **4B** zeigt einen Querschnitt durch einen Gitterfinger **GF** des Kontaktgitters **KG** bei einer punktförmigen Durchkontaktierung **DK.** Die **Figuren 5A, 5B** zeigt einen zu den **Figuren 4A, 4B** analogen Aufbau mit dem Unterschied, dass hier die Durchkontaktierung **DK** auf punktförmigen Metallspikes **MS** aus einem leitfähigen Material, beispielsweise Aluminium wie das Kontaktgitter **KG,** basiert (BSF-Wrap-Through-Konzept II).

### Dünnschichtbasierte Solarzelle mit frontseitiger Emitterschicht in Superstrat-Konfiguration und Emitterschicht -Durchkontaktierung (Emitter-Wrap-Through-Konzepte I, II)

Die **Figur 6A** zeigt einen Querschnitt durch eine dünnschichtbasierte Solarzelle **HKS** mit einer dünnen Absorberschicht **AS** auf einem Superstrat **SP** und einer Emitterschicht **ES** auf der im Betriebsfall lichtzugewandten Vorderseite **VS** der Solarzelle **HKS.** Der Querschnitt verläuft durch zwei Kontaktfinger **KF** des Kontaktgitters **KG** mit unterschiedlicher Ausführungshöhe. In der Praxis wird jeweils nur eine Möglichkeit durchgängig ausgeführt (gilt auch für nachfolgend dargestellte unterschiedliche Durchkontaktierungen). Die Emitterschicht **ES** ist über punktförmige Durchkontaktierungen **DK** (links elektrisch leitfähiges Polymer, rechts Metall) mit dem Kontaktgitter **KG** verbunden (Emitter-Wrap-Through-Konzept I). Die Absorberschicht **AS** ist mittels einer isolierenden Schutzschicht **OX** gegenüber dem Kontaktgitter **KG** elektrisch isoliert. Zwischen der dünnen Emitterschicht **ES** und dem Superstrat **SP** ist eine oder mehrere Zwischenschichten **ZS** vorgesehen. Die **Figur 6B** zeigt einen Längsschnitt durch einen Gitterfinger **GF** des Kontaktgitters **KG**.

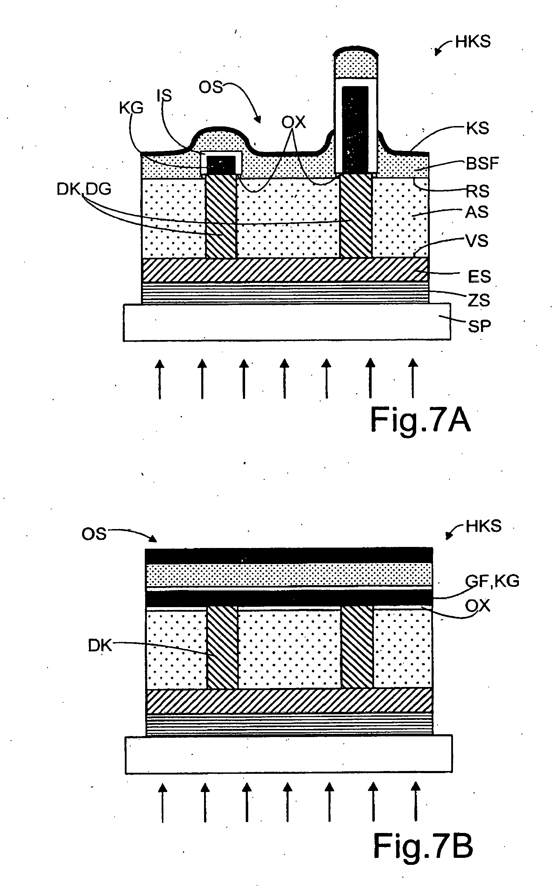

Die **Figuren 7A** und **7B** sind analog zu den **Figuren 6A** und **6B** aufgebaut. Gezeigt ist ein anderes Emitter-Wrap-Through-Konzept II mit breiten Durchkontaktierungen **DK.** Hierbei kann die isolierende Schutzschicht **OX** auf der Absorberschicht **AS** entfallen, wenn linienförmige Durchkontaktierungen **DK** vorgesehen sind, weil dann durch die Breite der Durchkontaktierungen **DK** auf der gesamten Länge der Gitterfinger **GF** bereits ein Kurzschluss der Absorberschicht **AS** mit dem Kontaktgitter **KG** verhindert wird.

### Dünnschichtbasierte Solarzelle mit rückseitiger Emitterschicht in Substrat-Konfiguration und Emitterschicht -Durchkontaktierung (Emitter-Wrap-Through-Konzepte I, II)

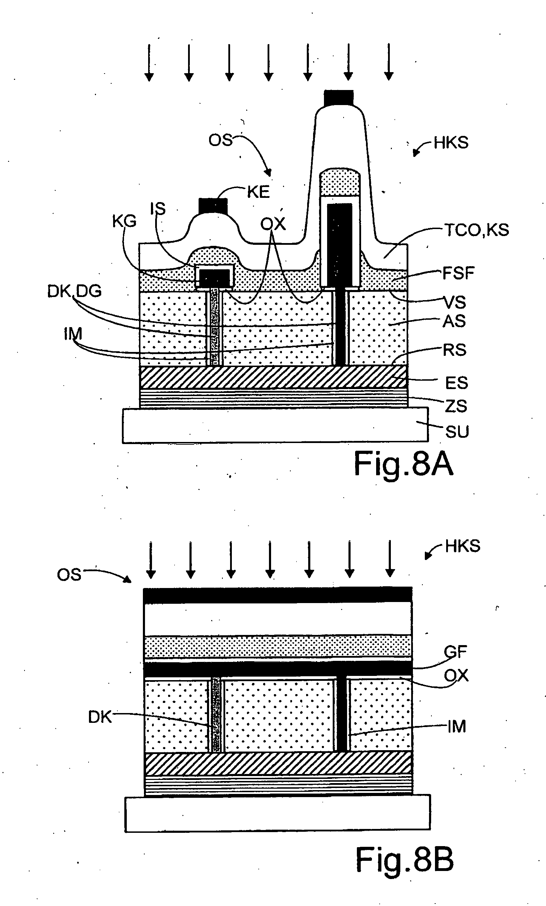

Analog zu den vorhergehenden Figuren mit einer Emitterschicht **ES** auf der im Betriebsfall lichtzugewandten Vorderseite **VS** der Solarzelle **HKS** zeigen die folgenden Figuren eine Konstellation der Emitterschicht **ES** auf der im Betriebsfall lichtabgewandten Rückseite **RS** der Solarzelle **HKS.** Die beiden Kontaktssysteme liegen dabei auf der Vorderseite **VS** der Solarzelle **HKS.** Die Kontaktschicht **KS** ist transparent ausgeführt und weist noch stromsammelnde Kontaktelemente **KE** auf, die zur Minimierung der Beschattungsverluste kongruent zum Kontaktgitter **KG** angeordnet sind. Die **Figur 8A** zeigt einen Querschnitt durch zwei Gitterfinger **GF** mit unterschiedlicher Ausführungshöhe. Bei einer Durchkontaktierung der Emitterschicht **ES** weist die auf einem Substrat **SU** aufgebrachte Absorberschicht **AS** wiederum eine isolierende Schutzschicht **OX** zur Vermeidung von Kurzschlüssen zum Kontaktgitter **KG** auf. Gezeigt sind zwei unterschiedliche punktförmige Durchkontaktierungen **DK.** Beide sind zunächst mit einem isolierenden Material **IM** ausgekleidet. Die linke Durchkontaktierung **DK** ist mit einem leitfähigen Polymer, die rechte mit einem Metall ausgefüllt. Die **Figur 8B** zeigt einen entsprechenden Längsschnitt durch einen Gitterfinger **GF.** Zu erkennen sind die beiden verschiedenen punktförmigen Durchkontaktierungen DK und die isolierenden Schutzschicht **OX** auf der Absorberschicht **AS**.

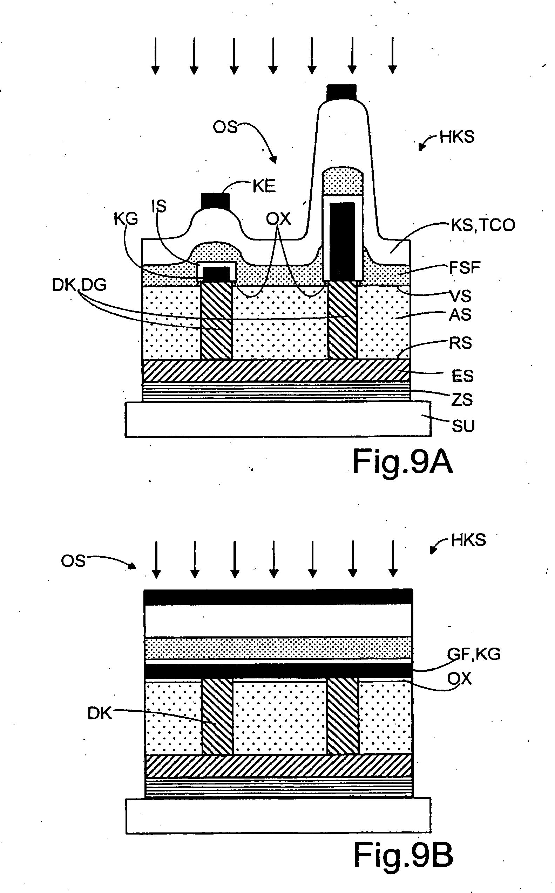

Die **Figuren 9A** und **9B** sind analog zu den **Figuren 8A** und **8B** aufgebaut. Gezeigt ist ein anderes Emitter-Wrap-Through-Konzept II mit breiten Durchkontaktierungen **DK.** Hierbei kann die isolierende Schutzschicht **OX** auf der Absorberschicht **AS** entfallen, wenn linienförmige Durchkontaktierungen **DK** vorgesehen sind, weil dann durch die Breite der Durchkontaktierungen **DK** auf der gesamten Länge der Gitterfinger **GF** bereits ein Kurzschluss der Absorberschicht **AS** mit dem Kontaktgitter **KG** verhindert wird.

### Dünnschichtbasierte Solarzelle mit rückseitiger Emitterschicht in Superstrat-Konfiguration und frontseitiger Feldpassivierungsschicht -Durchkontaktierung (FSF-Wrap-Through-Konzepte I, II)

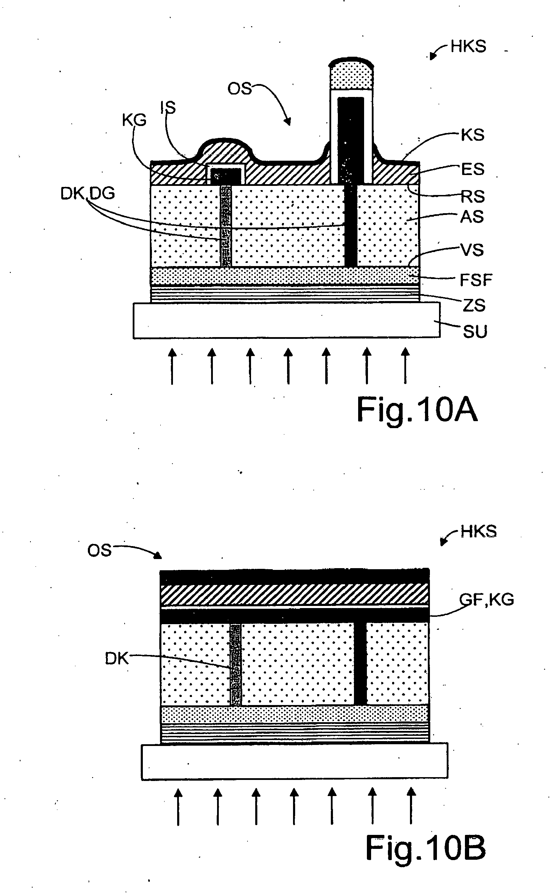

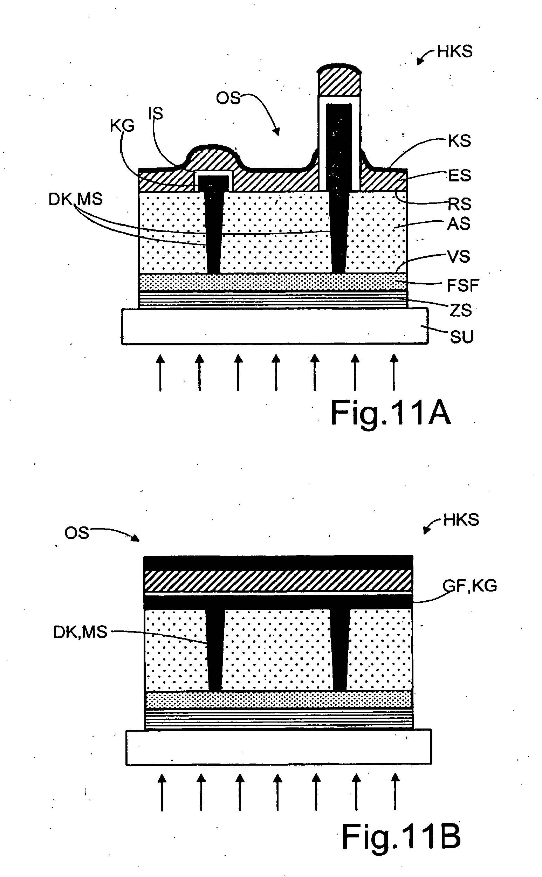

In den **Figuren 10A** und **10B** ist eine Solarzelle **HKS** mit einem Substrat **SU** dargestellt. Die Kontaktsysteme sind dementsprechend auf der Rückseite **RS** der Solarzelle **HKS** angeordnet. Die Kontaktschicht **KS** ist nicht transparent ausgeführt. Die Oberseite **OS** ist definiert als die dem Superstrat **SP** gegen-überliegende Seite der Solarzelle **HKS.** Die Figur **10A** zeigt einen Querschnitt durch zwei Kontaktfinger **KF** mit unterschiedlicher Ausführungshöhe. Die frontseitige Feldpassivierungsschicht **FSF** ist über Durchkontaktierungen **DK** mit dem Kontaktgitter **KG** verbunden (FSF-Wrap-Through-Konzept I). Gezeigt sind wiederum zwei verschiedene Durchkontaktierungen **DK** (links mit funktionellem Material der frontseitigen Feldpassivierungsschicht **FSF** gefüllt, rechts mit Metall gefüllt). Die **Figur 10B** zeigt einen Längsschnitt durch einen Gitterfinger **GF.** Die **Figuren 11A** und **11** **B** zeigen einen analogen Aufbau mit einem FSF-Wrap-Through-Konzept II. Dabei werden die Durchkontaktierungen **DK** durch Metallspikes **MS** gebildet.

### Dünnschichtbasierte Solarzelle mit Vorderseitenkontaktierung mit Serienverschaltung oder Parallelverschaltung

Die dünnschichtbasierte Solarzellenstruktur nach der Erfindung erlaubt eine einfache Serien- und Parallel-Verschaltung der einzelnen Solarzellen **HKS** mit nur zwei Strukturierungsschritten, wobei alle Solarzellenschichten weiterhin ganzflächig abgeschieden werden können.

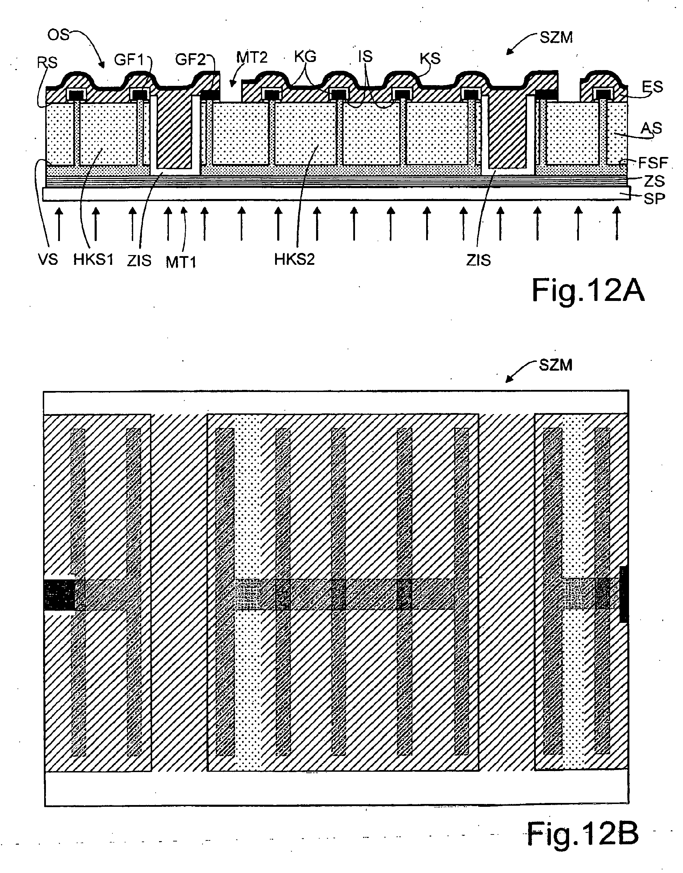

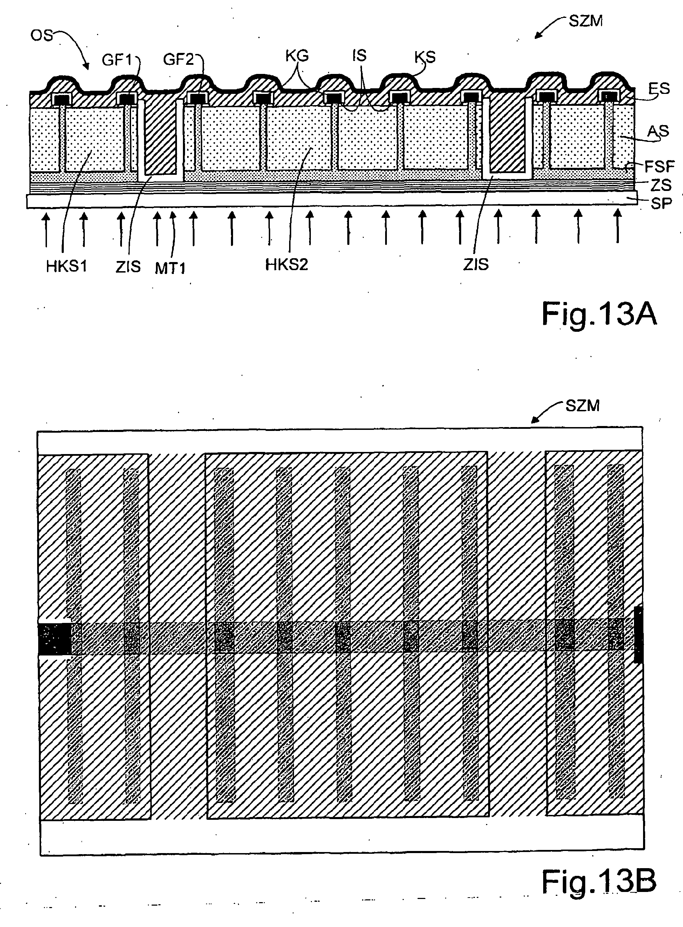

Die **Figur 12A** zeigt einen Querschnitt durch eine Serienverschaltung von einem rückseitenkontaktierten Solarzellenmodul **SZM** in SuperstratKonfiguration mit einer vorderseitigen, durchkontaktierten Emitterschicht **ES** und einer rückseitigen Feldpassivierungsschicht **BSF,** die **Figur 12B** zeigt eine Aufsicht auf die Rückseite des Solarzellenmoduls **SZM** unter Weglassung der Kontaktschicht **KS. Die** **Figuren 13A** und **13B** zeigen analog eine Querschnitt und eine Aufsicht durch eine Parallelverschaltung des Solarzellenmoduls **SZM.** Die Kontaktierung des Kontaktgitters **KG** erfolgt dann jeweils an der rechten Seite des Solarzellenmoduls **SZM,** die Kontaktierung der Kontaktschicht **KS** an der rechten Seite.

Unmittelbar nach dem Aufbringen des Kontaktgitters **KG** auf der Vorderseite **VS** der Absorberschicht **AS** oder nach dem Aufbringen der elektrischen Isolationsschicht **IS** auf das Kontaktgitter **KG** erfolgt ein erster Modulstrukturierungsschritt **MT1** in die einzelnen Solarzellen **HKS1, HKS2** (z.B. Erzeugen von schmalen Streifen durch mechanisches Kratzen oder Laser-Scribing). Diese Strukturierung durchtrennt mindestens die dünne Absorberschicht **AS** und die erste funktionelle Solarzellenschicht (hier **BSF**). Sie kann aber auch bis zum Substrat **SU** oder Superstrat **SP** herunter reichen (Durchtrennung der optionalen Zwischenschichten **ZS).** Idealerweise werden z.B. je zwei benachbarte Gitterfinger **GF1, GF2** die zu verschiedenen Solarzellen **HKS1, HKS2** gehören, so ausgelegt, dass der Zwischenraum zwischen diesen durch eine Laserstrukturierung entfernt wird. Zudem muss der entstandene Zwischenraum mit einer Zwischenraum-Isolationsschicht **ZIS** ummantelt werden (z.B. durch ein über die Laserstrukturierung entstandenes Oxid).

Im Falle einer Serien-Verschaltung **(****Figuren 12A, 12B****)** muss dann die Kontaktschicht **KS** der Solarzelle **HKS1** mit dem Gitterfinger **GF2** der Solarzelle **HKS2** kontaktiert werden. Im Falle einer Parallel-Verschaltung müssen jeweils die Kontaktschichten **KS** und die Kontaktgitter **KG** der einzelnen Solarzellen **HKS1,2** kontaktiert werden (die Kontaktschicht **KS** der Solarzelle **HKS1** mit der Kontaktschicht KS des Solarzellen **HKS2,** und der Gitterfinger **GF1** der Solarzelle **HKS1** mit dem Gitterfinger **GF2** der Solarzelle **HKS2).** Das heißt, im Falle einer Serien-Verschaltung muss erreicht werden, dass z.B. der Gitterfinger **GF1** elektrisch isoliert, der Gitterfinger **GF2** jedoch elektrisch nicht isoliert ist. Dies kann z.B. auf einfachste bei der elektrischen Isolierung des Kontaktgitters **KG** erfolgen, wenn die Isolationsschicht **IS** über Siebdruck aufgetragen wird. Alternativ ist z.B. auch ein nachträgliches punktuelles Durchfeuern mit einem Laser denkbar, dass eine ursprünglich vorhandene Isolationsschicht **IS** wieder zerstört. Im Falle einer Parallel-Verschaltung bleiben beide Gitterfinger **GF1, GF2** isoliert und die Verschaltung der Gitterfinger **GF1, GF2** erfolgt direkt durch den Steg **ST** (Busbar) des Kontaktgitters **KG.** Die erwünschte Serien- oder Parallel- Verschaltung erfolgt dann automatisch durch die ganzflächige Abscheidung der zweiten funktionellen Solarzellenschicht (hier rückseitige Feldpassivierungsschicht **BSF)** und der Kontaktschicht **KS.** Im Falle der Serien-Verschaltung erfolgt nach dem ganzflächigen Aufbringen der Kontaktschicht **KS** ein zweiter ModulStrukturierungsschritt **MT2,** der die zweite funktionelle Solarzellenschicht (hier rückseitige Feldpassivierungsschicht **BSF)** der Solarzelle **HKS1** von der Solarzelle **HKS2** trennt.

Alternativ kann die Erzeugung der Solarzellen **HKS** auch erst nach dem Aufbringen der Kontaktschicht **KS** durchgeführt werden (erster Modulstrukturierungsschritt **MT1).** Es werden dann die Verschaltungsmethoden verwendet, wie sie bereits bei den rückseitenkontaktierten, waferbasierten Solarzellen **HKS** geschildert worden sind. Dadurch entfällt der zweite Modul-strukturierungsschritt **MT2,** die Serien- bzw. Parallelverschaltung muss aber noch nachträglich erfolgen.

### Bezugszeichenliste

- **AS**: Absorberschicht
- **BSF**: rückseitige Feldpassivierungsschicht
- **DG**: Durchgangsöffnung
- **DK**: Durchkontaktierung
- **ES**: Emitterschicht
- **FS**: funktionelle Schicht
- **FSF**: frontseitige Feldpassivierungsschicht
- **GF**: Gitterfinger
- **HKS**: Solarzelle (Ausführungsform Heterokontakt-Solarzelle)
- **IM**: isolierendes Material
- **IS**: elektrisch nicht leitende Isolationsschicht
- **KB**: Kupferband
- **KE**: Kontaktelement
- **KG**: Kontaktgitter
- **KS**: Kontaktschicht
- **MS**: Metallspike
- **MT**: Modulstrukturierungsschritt
- **OS**: Oberseite (zugängliche Seite) von HKS
- **OX**: elektrisch isolierende Schutzschicht
- **PV**: Parallelverschaltung
- **RS**: Rückseite (für den Lichteinfall nicht vorgesehene Seite) von AS
- **SP**: Superstrat
- **ST**: Steg
- **SU**: Substrat
- **SV**: Serienverschaltung
- **SZM**: Solarzellen-Modul
- **TCO**: transparente leitfähige Oxidschicht
- **VS**: Vorderseite (für den Lichteinfall vorgesehene Seite) von AS
- **ZIS**: Zwischen-Isolationsschicht
- **ZS**: Zwischenschicht

## Patentansprüche

1. Einseitig kontaktierte Solarzelle aus zumindest einer mit Durchkontaktierungen strukturierten Absorberschicht und einer auf einer Seite der Absorberschicht ganzflächig angeordneten Emitterschicht aus Halbleitermaterialien unterschiedlicher Dotierung, wobei überschüssige Ladungsträger in der Absorberschicht durch Lichteinfall erzeugt, am pn-Übergang zwischen Absorber- und Emitterschicht getrennt und über zwei, gemeinsam auf einer Seite der Absorberschicht angeordnete, elektrisch von außen kontaktierte und gegeneinander isolierte Kontaktsysteme gesammelt und abgeleitet werden, wobei das eine Kontaktsystem auf der Absorberschicht angeordnet und als Kontaktgitter, das zumindest auf seiner gesamten Oberseite mit einer Isolationsschicht bedeckt und mit den Durchkontaktierungen an ihren einen Enden elektrisch leitend verbunden ist, und das andere Kontaktsystem als ganzflächige Kontaktschicht ausgebildet ist,
**gekennzeichnet durch**
■ eine Anordnung einer ganzflächigen Feldpassivierungsschicht (FSF/BSF) auf der der Emitterschicht (ES) gegenüberliegenden Seite der Absorberschicht (AS),
■ eine Anordnung des zumindest auf seiner gesamten Oberseite mit einer Isolationsschicht bedeckten Kontaktgitters (KG) zwischen der Absorberschicht (AS) und der Feldpassivierungsschicht (FSF/BSF),
■ eine Anordnung der Kontaktschicht (KS) auf der Feldpassivierungsschicht (FSF/BSF), sodass beide Kontaktsysteme leicht zugänglich auf der Oberseite (OS) der Solarzelle (HKS) angeordnet sind, und
■ eine elektrisch leitende Verbindung der Durchkontaktierungen (DK) an ihren dem Kontaktgitter (KG) gegenüberliegenden Enden mit der Emitterschicht (ES), wobei zwischen der Absorberschicht (AS) und dem Kontaktgitter (KG) keine elektrisch leitende Verbindung besteht.

2. Einseitig kontaktierte Solarzelle aus zumindest einer mit Durchkontaktierungen strukturierten Absorberschicht und einer auf einer Seite der Absorberschicht ganzflächig angeordneten Emitterschicht aus Halbleitermaterialien unterschiedlicher Dotierung, wobei überschüssige Ladungsträger in der Absorberschicht durch Lichteinfall erzeugt, am pn-Übergang zwischen Absorber- und Emitterschicht getrennt und über zwei, gemeinsam auf einer Seite der Absorberschicht angeordnete, elektrisch von außen kontaktierte und gegeneinander isolierte Kontaktsysteme gesammelt und abgeleitet werden, wobei das eine Kontaktsystem auf der Absorberschicht angeordnet und als Kontaktgitter, das zumindest auf seiner gesamten Oberseite mit einer Isolationsschicht bedeckt und mit den Durchkontaktierungen an ihren einen Enden elektrisch leitend verbunden ist, und das andere Kontaktsystem als ganzflächige Kontaktschicht ausgebildet ist,
**gekennzeichnet durch**
**■** eine Anordnung einer ganzflächigen Feldpassivierungsschicht (FSF/BSF) auf der der Emitterschicht (ES) gegenüberliegenden Seite der Absorberschicht (AS),
■ eine Anordnung des zumindest auf seiner gesamten Oberseite mit einer Isolationsschicht bedeckten Kontaktgitters (KG) zwischen der Absorberschicht (AS) und der Emitterschicht (ES),
■ eine Anordnung der Kontaktschicht (KS) auf der Emitterschicht (ES), sodass beide Kontaktsysteme leicht zugänglich auf der Oberseite (OS) der Solarzelle (HKS) angeordnet sind, und
■ eine elektrisch leitende Verbindung der Durchkontaktierungen (DK) an ihren dem Kontaktgitter (KG) gegenüberliegenden Enden mit der Feldpassivierungsschicht (FSF/BSF).

3. Verfahren zur Herstellung einer einseitig kontaktierten Solarzelle nach Anspruch 1 oder 2
mit einer Absorberschicht (AS) in Form eines Wafers (WF) und einer Anordnung beider Kontaktsysteme auf der Rückseite (RS), **gekennzeichnet durch**
folgende Verfahrensschritte:
(I) Strukturieren des Wafers (WF) zum Erzeugen von punkt- oder linien- oder gitter- oder netzförmigen Durchkontaktierungen (DK),
(II) ganzflächiges Texturieren und Passivieren der Vorderseite (VS) des Wafers (WF)
(III) ganzflächiges Erzeugen einer Emitterschicht (ES) oder einer Feldpassivierungsschicht (FSF/BSF) auf der Vorderseite (VS) des Wafers (WF) unter Einbeziehen der Durchkontaktierungen (DK),
(IV) Abscheiden eines Kontaktgitters (KG) auf der Rückseite (RS) des Wafers (WF) unter Überdecken der Durchkontaktierungen (DK),
(V) Erzeugen einer elektrischen Isolationsschicht (IS) auf der gesamten freien Oberfläche des Kontaktgitters (KG),
(VII) ganzflächiges Abscheiden der noch nicht abgeschiedenen Feldpassivierungsschicht (FSF/BSF) oder Emitterschicht (ES) auf der Rückseite (RS) des Wafers (WF) mit dem isolierten Kontaktgitter (KG) unter gleichzeitiger Grenzflächenpassivierung der freien Bereiche des Wafers (WF),
(VIII) ganzflächiges Abscheiden einer Kontaktschicht (KS) auf der abgeschiedenen Emitterschicht (ES) oder Feldpassivierungsschicht (FSF/BSF) auf der Rückseite des Wafers (WF) und
(IX) elektrisches Kontaktieren des Kontaktgitters (KG) und der Kontaktschicht (KS).

4. Verfahren zur Herstellung einer einseitig kontaktierten Solarzelle nach Anspruch 1 oder 2
mit einer dünnschichtbasierten Absorberschicht (AS) und einer Anordnung beider Kontaktsysteme auf der Oberseite (OS), **gekennzeichnet durch** folgende Verfahrensschritte:
(I) Aufbringen einer Emitterschicht (ES) oder einer Feldpassivierungsschicht (FSF/BSF) und einer Absorberschicht (AS) auf einem Substrat (SU) oder Superstrat (SP),
(II) Strukturieren der Absorberschicht (AS) mit einfachen Durchgangsöffnungen (DG) zum Erzeugen von punkt- oder linien- oder gitter- oder netzförmigen Durchkontaktierungen (DK) der Emitterschicht (ES) oder Feldpassivierungsschicht (FSF/BSF) **durch** die Absorberschicht (AS),
(III) Befüllen der Durchgangsöffnungen (DG) mit einem funktionellen Schichtmaterial oder einem elektrisch leitenden Material,
(IV) Abscheiden eines Kontaktgitters (KG) auf der Oberseite (OS) der Absorberschicht (AS) unter Überdeckung der Durchkontaktierungen (DK),
(V) Erzeugen einer elektrischen Isolationsschicht (IS) auf der gesamten freien Oberfläche des Kontaktgitters (KG),
(VI) ganzflächiges Abscheiden der noch nicht abgeschiedenen Emitterschicht (ES) oder der Feldpassivierungsschicht (FSF/BSF) auf der Oberseite (OS) der Absorberschicht (AS) mit dem Kontaktgitter (KG) unter gleichzeitiger Grenzflächenpassivierung der freien Bereiche der Absorberschicht (AS),
(VII) ganzflächiges Abscheiden einer Kontaktschicht (KS) auf der abgeschiedenen Emitterschicht (ES) oder Feldpassivierungsschicht (FSF/BSF) auf der Seite der Absorberschicht (AS) mit dem Kontaktgitter (KG) und
(VIII) elektrisches Kontaktieren des Kontaktgitters (KG) und der Kontaktschicht (KS).

5. Verfahren zur Herstellung einer einseitig kontaktierten Solarzelle nach Anspruch 1 oder 2
mit einer dünnschichtbasierten Absorberschicht (AS) und einer Anordnung beider Kontaktsysteme auf der Oberseite (OS), **gekennzeichnet durch** folgende Verfahrensschritte:
(I) Aufbringen einer Feldpassivierungsschicht (FSF/BSF) und einer Absorberschicht (AS) auf einem Substrat (SU) oder Superstrat (SP),
(II) Abscheiden eines Kontaktgitters (KG) auf der Oberseite (OS) der Absorberschicht (AS),
(III) Tempern des Kontaktgitters (KG) zur Bildung von Durchkontaktierungen (DK) in Form von Metallspikes (MS),
(IV) Erzeugen einer elektrischen Isolationsschicht (IS) auf der gesamten freien Oberfläche des Kontaktgitters (KG),
(V) ganzflächiges Abscheiden einer Emitterschicht (ES) auf der Oberseite (OS) der Absorberschicht (AS) mit dem Kontaktgitter (KG) unter gleichzeitiger Passivierung der freigelegten Bereiche der Absorberschicht (AS),
(VI) ganzflächiges Abscheiden einer Kontaktschicht (KS) auf der abgeschiedenen Emitterschicht (ES) und
(VII) elektrisches Kontaktieren des Kontaktgitters (KG) und der Kontaktschicht (KS).

6. Verfahren zur Herstellung einer einseitig kontaktierten Solarzelle nach Anspruch 1 oder 2
mit einer dünnschichtbasierten Absorberschicht (AS) und einer Anordnung beider Kontaktsysteme auf der Oberseite (OS), **gekennzeichnet durch** folgende Verfahrensschritte:
(I) Aufbringen einer Feldpassivierungsschicht (FSF/BSF) und einer Absorberschicht (AS) auf einem Substrat (SU) oder Superstrat (SP),
(II) Abscheiden von Punktkontakten auf der Oberseite (OS) der Absorberschicht (AS),
(III) Tempern der Punktkontakte zur Bildung von Durchkontaktierungen (DK) in Form von Metallspikes (MS),
(IV) Abscheiden eines Kontaktgitters (KG) auf der Oberseite der Absorberschicht (AS) unter Überdeckung der Punktkontakte,
(IV) Erzeugen einer elektrischen Isolationsschicht (IS) auf der gesamten freien Oberfläche des Kontaktgitters (KG),
(V) ganzflächiges Abscheiden einer Emitterschicht (ES) auf der Oberseite (OS) der Absorberschicht (AS) mit dem Kontaktgitter (KG) unter gleichzeitiger Passivierung der freigelegten Bereiche der Absorberschicht (AS),
(VI) ganzflächiges Abscheiden einer Kontaktschicht (KS) auf der abgeschiedenen Emitterschicht (ES) und
(VII) elektrisches Kontaktieren des Kontaktgitters (KG) und der Kontaktschicht (KS).

7. Verfahren nach einem der Ansprüche 3 bis 6,
**gekennzeichnet durch**
Aufbringen einer ganzflächigen elektrisch isolierenden Schutzschicht (OX) auf der Oberseite (OS) der Absorberschicht vor dem Aufbringen des Kontaktgitters (KG) zwingend bei einer Durchkontaktierung der Emitterschicht (ES) und optional bei einer Durchkontaktierung einer Feldpassivierungsschicht (FSF, BSF) und
Freilegen der Oberseite (OS) der Absorberschicht (AS) mit dem Kontaktgitter (KG) von der elektrisch isolierenden Schutzschicht (OX) vor dem Abscheiden der Emitterschicht (ES) oder der Feldpassivierungsschicht (FSF/BSF) ohne Beeinträchtigung der Isolationsschicht (IS) auf dem Kontaktgitter (KG),

8. Verfahren nach einem der Ansprüche 3 bis 6,
**gekennzeichnet durch**
Freilegen der Oberseite (OS) der Absorberschicht (AS) mit dem Kontaktgitter (KG) von Verunreinigungen vor dem Abscheiden der Emitterschicht (ES) oder der Feldpassivierungsschicht (FSF/BSF) ohne Beeinträchtigung der Isolationsschicht (IS) auf dem Kontaktgitter (KG).

9. Verfahren nach einem der Ansprüche 3 bis 8,
**gekennzeichnet durch**
Strukturieren der Absorberschicht (AS) **durch** Erzeugen von punkt-, liniengitter- oder netzförmigen Durchgangsöffnungen (DG) **durch** Ätz- oder Laserbehandlung.

10. Verfahren nach Anspruch 9,
**gekennzeichnet durch**
Füllen der Durchgangsöffnungen (DG) mit elektrisch leitfähigen Material, wobei zumindest bei einer Durchkontaktierung (DK) der Emitterschicht (ES) die Durchgangsöffnungen (DG) vorher mit einem elektrisch isolierenden Material (IM) ausgekleidet werden.

11. Verfahren nach Anspruch 10,
**gekennzeichnet durch**
Füllen der Durchgangsöffnungen (DG) mit einem mit Halbleitermaterial mit derselben Funktionalität wie die Emitterschicht (ES) oder die Feldpassivierungsschicht (FSF/BSF).

12. Verfahren nach einem der Ansprüche 3 bis 11,
**gekennzeichnet durch**
Bilden eines Steges (ST) als Anschlussbereich am Rand der Absorberschicht (AS) beim Abscheiden des Kontaktgitters (KG), Aussparen des Anschlussbereiches während der Abscheidung der Emitterschicht (ES) oder der Feldpassivierungsschicht (FSF/BSF) auf der Rückseite der Absorberschicht (AS) und Freilegen des Anschlussbereiches.

13. Verfahren nach einem der Ansprüche 3 bis 12,
**gekennzeichnet durch**
zusätzliches Abscheiden von weiteren funktionellen Schichten (FS), insbesondere auch Pufferschchten oder Saatschichten, **durch** thermisches Verdampfen, Sputtern oder Gasphasenabscheidung, wobei einzelne funktionelle Schichten (FS) mehrere Funktionen aufweisen können.

## Claims

1. A solar cell contacted from one side, consisting of at least one absorber layer structured with through contacts, and one emitter layer, consisting of semiconductor materials with various forms of doping, arranged over the whole surface area on one face of the absorber layer, wherein excess charge carriers are generated in the absorber layer by incident light, are separated at the pn-transition between the absorber and emitter layers and are collected and redirected via two contact systems, arranged together on one face of the absorber layer, with external electrical contacts and insulated with respect to one another, wherein the one contact system is arranged on the absorber layer and is designed as a contact grid, which is covered at least on the whole of its upper face with an insulation layer, and is connected in an electrically conducting manner with the through contacts at its one end, and the other contact system is designed as a whole surface area contact layer, **characterised by**
■ an arrangement of a whole surface area field passivation layer (FSF/BSF) on the face of the absorber layer (AS) located opposite to the emitter layer (ES),
■ an arrangement of the contact grid (KG). covered at least on the whole of its upper face with an insulation layer, between the absorber layer (AS) and the field passivation layer (FSF/BSF),
■ an arrangement of the contact layer (KS) on the field passivation layer (FSF/BSF) such that both contact systems are arranged so as to be easily accessible on the upper face (OS) of the solar cell (HKS), and
■ an electrically conducting connection of the through contacts (DK) on their ends located opposite to the contact grid (KG) with the emitter layer (ES), wherein no electrically conducting connection exists between the absorber layer (AS) and the contact grid (KG).

2. The solar cell contacted from one side, consisting of at least one absorber layer structured with through contacts and one emitter layer, consisting of semiconductor materials with various forms of doping, arranged over the whole surface area on one face of the absorber layer, wherein excess charge carriers are generated in the absorber layer by incident light, are separated at the pn-transition between the absorber and emitter layers and are collected and redirected via two contact systems, arranged together on one face of the absorber layer, with external electrical contacts and insulated with respect to one another, wherein the one contact system is arranged on the absorber layer and is designed as a contact grid, which is covered at least on the whole of its upper face with an insulation layer and is connected in an electrically conducting manner with the through contacts on its one end, and the other contact system is designed as a whole surface area contact layer, **characterised by**
■ an arrangement of a whole surface area field passivation layer (FSF/BSF) on the face of the absorber layer (AS) located opposite to the emitter layer (ES),
■ an arrangement of the contact grid (KG), covered at least on the whole of its upper face with an insulation layer, between the absorber layer (AS) and the emitter layer (ES),
■ an arrangement of the contact layer (KS) on the emitter layer (ES), such that both contact systems are arranged so as to be easily accessible on the upper face (OS) of the solar cell (HKS), and
■ an electrically conducting connection of the through contacts (DK) on their ends located opposite to the contact grid (KG) with the field passivation layer (FSF/BSF).

3. A method for the manufacture of a solar cell contacted from one side in accordance with Claim 1 or 2, with an absorber layer (AS) in the form of a wafer (WF) and an arrangement of both contact systems on the rear face (RS), **characterised by** the following steps in the method:
(I) structuring of the wafer (WF) for purposes of generating through contacts (DK) in the form of points, or lines, or grids, or networks,
(II) whole surface area texturing and passivation of the front face (VS) of the wafer (WF),
(III) whole surface area generation of an emitter layer (ES) or a field passivation layer (FSF/BSF) on the front face (VS) of the wafer (WF) with incorporation of the through contacts (DK),
(IV) deposition of a contact grid (KG) on the rear face (RS) of the wafer (WF) with covering of the through contacts (DK),
(V) generation of an electrical insulation layer (IS) on the whole of the free surface area of the contact grid (KG),
(VII) whole surface area deposition of the not yet deposited field passivation layer (FSF/BSF) or emitter layer (ES) on the rear face (RS) of the wafer (WF) with the insulated contact grid (KG) with simultaneous interfacial passivation of the free regions of the wafer (WF),
(VIII) whole surface area deposition of a contact layer (KS) on the deposited emitter layer (ES) or field passivation layer (FSF/BSF) on the rear face (RS) of the wafer (WF), and
(IX) formation of electrical contact between the contact grid (KG) and contact layer (KS).

4. The method for the manufacture of a solar cell contacted from one side in accordance with Claim 1 or 2, with a thin layer-based absorber layer (AS) and an arrangement of both contact systems on the upper face (OS), **characterised by** the following steps in the method:
(I) application of an emitter layer (ES) or a field passivation layer (FSF/BSF) and an absorber layer (AS) on a substrate (SU) or superstrate (SP),
(II) structuring of the absorber layer (AS) with simple through openings (DG) for purposes of generating through contacts (DK) of the emitter layer (ES) or field passivation layer (FSF/BSF) through the absorber layer, (AS) in the form of points, or lines, or grids, or networks,
(III) filling of the through openings (DG) with a functional layer material or an electrically conducting material,
(IV) deposition of a contact grid (KG) on the upper face (OS) of the absorber layer (AS) with covering of the through contacts (DK),
(V) generation of an electrical insulation layer (IS) on the whole of the free surface area of the contact grid (KG),
(VI) whole surface area deposition of the not yet deposited emitter layer (ES) or field passivation layer (FSF/BSF) on the upper face (OS) of the absorber layer (AS) with the contact grid (KG), with simultaneous interfacial passivation of the free regions of the absorber layer (AS),
(VII) whole surface area deposition of a contact layer (KS) on the deposited emitter layer (ES) or field passivation layer (FSF/BSF) on the face of the absorber layer (AS) with the contact grid (KG), and
(VIII) formation of electrical contact between the contact grid (KG) and contact layer (KS).

5. The method for the manufacture of a solar cell contacted from one side in accordance with Claim 1 or 2, with a thin layer-based absorber layer (AS) and an arrangement of both contact systems on the upper face (OS), **characterised by** the following steps in the method:
(I) application of a field passivation layer (FSF/BSF) and an absorber layer (AS) on a substrate (SU) or superstrate (SP),
(II) deposition of a contact grid (KG) on the upper face (OS) of the absorber layer (AS),
(III) heat treatment of the contact grid (KG) for purposes of forming through contacts (DK) in the form of metal spikes (MS),
(IV) generation of an electrical insulation layer (IS) on the whole of the free surface area of the contact grid (KG),
(V) whole surface area deposition of an emitter layer (ES) on the upper face (OS) of the absorber layer (AS) with the contact grid (KG) with simultaneous passivation of the exposed regions of the absorber layer (AS),
(VI) whole surface area deposition of a contact layer (KS) on the deposited emitter layer (ES), and
(VII) formation of electrical contact between the contact grid (KG) and contact layer (KS).

6. The method for the manufacture of a solar cell contacted from one side in accordance with Claim 1 or 2, with a thin layer-based absorber layer (AS) and an arrangement of both contact systems on the upper face (OS), **characterised by** the following steps in the method:
(I) application of a field passivation layer (FSF/BSF) and an absorber layer (AS) on a substrate (SU) or superstrate (SP),
(II) deposition of point contacts on the upper face (OS) of the absorber layer (AS),
(III) heat treatment of the point contacts for purposes of forming through contacts (DK) in the form of metal spikes (MS),
(IV) deposition of a contact grid (KG) on the upper face (OS) of the absorber layer (AS) with covering of the point contacts,
(IV) generation of an electrical insulation layer (IS) on the whole of the free surface area of the contact grid (KG),
(V) whole surface area deposition of an emitter layer (ES) on the upper face (OS) of the absorber layer (AS) with the contact grid (KG) with simultaneous passivation of the exposed regions of the absorber layer (AS),
(VI) whole surface area deposition of a contact layer (KS) on the deposited emitter layer (ES), and
(VII) formation of electrical contact between the contact grid (KG) and contact layer (KS).

7. The method in accordance with one of the Claims 3 to 6, **characterised by** application of a whole surface area electrically insulating protective layer (OX) on the upper face (OS) of the absorber layer (AS) before the application of the contact surface (KG), compulsory in the case of a through contact of the emitter layer (ES), and optional in the case of a through contact of a field passivation layer (FSF/BSF), and clearance of the upper face (OS) of the absorber layer (AS) with the contact grid (KG) from the electrically insulating protective layer (OX) before the deposition of the emitter layer (ES) or the field passivation layer (FSF/BSF) without impairment of the insulation layer (IS) on the contact grid (KG),

8. The method in accordance with one of the Claims 3 to 6, **characterised by** clearance of the upper face (OS) of the absorber layer (AS) with the contact grid (KG) from contaminants before the deposition of the emitter layer (ES) or the field passivation layer (FSF/BSF) without impairment of the insulation layer (IS) on the contact grid (KG),

9. The method in accordance with one of the Claims 3 to 8, **characterised by** structuring of the absorber layer (AS) for purposes of generating through openings (DG) in the form of points, or lines, or grids, or networks by an etching treatment or a laser treatment.

10. The method in accordance with Claim 9, **characterised by** filling of the through openings (DG) with an electrically conducting material, wherein at least in the case of a through contact (DK) of the emitter layer (ES) the through openings (DG) are previously coated with electrically insulating material (IM).

11. The method in accordance with Claim 10, **characterised by** filling of the through openings (DG) with a semiconductor material with the same functionality as the emitter layer (ES) or the field passivation layer (FSF/BSF).

12. The method in accordance with one of the Claims 3 to 11, **characterised by** formation of a bridge (ST) as a connecting region at the edge of the absorber layer (AS) during the deposition of the contact grid (KG), leaving the connecting region blank during the deposition of the emitter layer (ES) or the field passivation layer (FSF/BSF) on the rear face of the absorber layer (AS) and exposing the connecting region.

13. The method in accordance with one of the Claims 3 to 12, **characterised by** vaporisation, sputtering, or gas phase deposition, wherein individual functional layers (FS) can have a plurality of functions.

## Revendications

1. Cellule solaire à contact unilatéral se composant d'au moins une couche absorbante structurée par des trous métallisés et d'une couche émettrice en matériaux semi-conducteurs à différents dopages disposée sur toute la surface d'un côté de la couche absorbante, des porteurs de charge excédentaires étant générés dans la couche absorbante grâce à de la lumière incidente, étant séparés à la transition pn entre les couches absorbante et émettrice et étant collectés et évacués grâce à deux systèmes de contact qui sont disposés ensemble sur un côté de la couche absorbante, sont contactés électriquement depuis l'extérieur et isolés l'un par rapport à l'autre, moyennant quoi l'un des systèmes de contact est disposé sur la couche absorbante et est réalisé en tant que grille de contact, laquelle est recouverte d'une couche d'isolation au moins sur l'ensemble de sa face supérieure et est connectée de manière électro-conductrice aux trous métallisés au niveau d'une de leurs extrémités, et l'autre des systèmes de contact étant réalisé en tant que couche de contact de surface complète, **caractérisée par**
■ un agencement d'une couche de passivation de champ de surface complète (FSB/BSF) sur le côté de la couche absorbante (AS) situé en vis-à-vis de la couche émettrice (ES),
■ un agencement de la grille de contact (KG), recouverte au moins sur l'ensemble de sa face supérieure d'une couche d'isolation, entre la couche absorbante (AS) et la couche de passivation de champ (FSF/BSF),
■ un agencement de la couche de contact (KS) sur la couche de passivation de champ (FSF/BSF) de sorte que les deux systèmes de contact sont disposés de manière facilement accessible sur la face supérieure (OS) de la cellule solaire (HKS), et
■ une liaison électro-conductrice entre les trous métallisés (DK), au niveau de leurs extrémités situées en vis-à-vis de la grille de contact (KG), et la couche émettrice (ES), moyennant quoi il n'y a pas de liaison électro-conductrice entre la couche absorbante (AS) et la grille de contact (KG).

2. Cellule solaire à contact unilatéral se composant d'au moins une couche absorbante structurée par des trous métallisés et d'une couche émettrice en matériaux semi-conducteurs à différents dopages disposée sur toute la surface d'un côté de la couche absorbante, des porteurs de charge excédentaires étant générés dans la couche absorbante grâce à de la lumière incidente, étant séparés à la transition pn entre les couches absorbante et émettrice et étant collectés et évacués grâce à deux systèmes de contact qui sont disposés ensemble sur un côté de la couche absorbante, sont contactés électriquement depuis l'extérieur et isolés l'un par rapport à l'autre, moyennant quoi l'un des systèmes de contact est disposé sur la couche absorbante et est réalisé en tant que grille de contact, laquelle est recouverte d'une couche d'isolation au moins sur l'ensemble de sa face supérieure et est connectée de manière électro-conductrice aux trous métallisés au niveau d'une de leurs extrémités, et l'autre des systèmes de contact étant réalisé en tant que couche de contact de surface complète, **caractérisée par**
■ un agencement d'une couche de passivation de champ de surface complète (FSB/BSF) sur le côté de la couche absorbante (AS) situé en vis-à-vis de la couche émettrice (ES),
■ un agencement de la grille de contact (KG), recouverte au moins sur l'ensemble de sa face supérieure d'une couche d'isolation, entre la couche absorbante (AS) et la couche émettrice (ES),
■ un agencement de la couche de contact (KS) sur la couche émettrice (ES), de sorte que les deux systèmes de contact sont disposés de manière facilement accessible sur la face supérieure (OS) de la cellule solaire (HKS), et
■ une liaison électro-conductrice entre les trous métallisés (DK), au niveau de leurs extrémités situées en vis-à-vis de la grille de contact (KG), et la couche de passivation de champ (FSF/BSF).

3. Procédé pour la fabrication d'une cellule solaire à contact unilatéral selon les revendications 1 ou 2 avec une couche absorbante (AS) sous la forme d'une tranche (WF) et un agencement des deux systèmes de contact sur la face arrière (RS), **caractérisé par** les étapes suivantes du procédé:
(I) structuration de la tranche (WF) pour la production de trous métallisés (DK) en forme de points, ou de lignes, ou de grilles, ou de réseaux,
(II) texturation sur toute la surface et passivation de la face avant (VS) de la tranche (WF),
(III) production, sur toute la surface, d'une couche émettrice (ES) ou d'une couche de passivation de champ (FSF/BSF) sur la face avant (VS) de la tranche (WF) en incluant les trous métallisés (DK),
(IV) dépôt d'une grille de contact (KG) sur la face arrière (RS) de la tranche (WF) en recouvrant les trous métallisés (DK),
(V) génération d'une couche d'isolation électrique (IS) sur toute la surface libre de la grille de contact (KG),
(VII) dépôt, sur toute la surface, de la couche de passivation de champ (FSF/BSF) ou de la couche émettrice (ES) non encore déposée sur la face arrière (RS) de la tranche (WF) avec la grille de contact (KG) isolée tout en passivant simultanément des surfaces limitrophes des zones libres de la tranche (WF),
(VIII) dépôt, sur toute la surface, d'une couche de contact (KS) sur la couche émettrice (ES) ou la couche de passivation de champ (FSF/BSF) déposée sur la face arrière de la tranche (WF) et
(IX) mise en contact électrique de la grille de contact (KG) et de la couche de contact (KS).

4. Procédé pour la fabrication d'une cellule solaire à contact unilatéral selon les revendications 1 ou 2 avec une couche absorbante (AS) à base d'une couche mince et un agencement des deux systèmes de contact sur la face supérieure, **caractérisé par** les étapes suivantes du procédé:
(I) application d'une couche émettrice (ES) ou d'une couche de passivation de champ (FSF/BSF) et d'une couche absorbante (AS) sur un substrat (SU) ou un super substrat (SP),
(II) structuration de la couche absorbante (AS) avec des ouvertures de passage (DG) simples pour la production de trous métallisés (DK) en forme de points, ou de lignes, ou de grilles, ou de réseaux de la couche émettrice (ES) ou de la couche de passivation de champ (FSF/BSF) à travers la couche absorbante (AS) ;
(III) remplissage des ouvertures de passage (DG) avec un matériau de couche fonctionnel ou un matériau électro-conducteur,
(IV) dépôt d'une grille de contact (KG) sur la face supérieure (OS) de la couche absorbante (AS) en recouvrant les trous métallisés (DK),
(V) génération d'une couche d'isolation électrique (IS) sur l'ensemble de la surface libre de la grille de contact (KG),
(VI) dépôt, sur toute la surface, de la couche d'émission (ES) ou de la couche de passivation (FSF/BSF) non encore déposée sur la face supérieure (OS) de la couche absorbante (AS) avec la grille de contact (KG) en réalisant une passivation simultanée des surfaces limitrophes des zones libres de la couche absorbante (AS),
(VII) dépôt, sur toute la surface, d'une couche de contact (KS) sur la couche émettrice (ES) ou la couche de passivation de champ (FSF/BSF) déposée sur le côté de la couche absorbante (AS) avec la grille de contact (KG), et
(VIII) mise en contact électrique de la grille de contact (KG) et de la couche de contact (KS).

5. Procédé pour la fabrication d'une cellule solaire à contact unilatéral selon les revendications 1 ou 2 avec une couche absorbante (AS) à base d'une couche mince et un agencement des deux systèmes de contact sur la face supérieure (OS), **caractérisé par** les étapes suivantes du procédé:
(I) application d'une couche de passivation de champ (FSF/BSF) et d'une couche absorbante (AS) sur un substrat (SU) ou un super substrat (SP),
(II) dépôt d'une grille de contact (KG) sur la face supérieure (OS) de la couche absorbante (AS),
(III) exécution d'un recuit de la grille de contact (KG) pour la formation de trous métallisés (DK) sous la forme de pointes métalliques (MS),
(IV) génération d'une couche d'isolation électrique (IS) sur l'ensemble de la surface libre de la grille de contact (KG),
(V) dépôt, sur toute la surface, d'une couche émettrice (ES) sur la face supérieure (OS) de la couche absorbante (AS) avec la grille de contact (KG) tout en passivant simultanément les zones dégagées de la couche absorbante (AS),
(VI) dépôt, sur toute la surface, d'une couche de contact (KS) sur la couche émettrice (ES) déposée et
(VII) mise en contact électrique de la grille de contact (KG) et de la couche de contact (KS).

6. Procédé pour la fabrication d'une cellule solaire à contact unilatéral selon les revendications 1 ou 2 avec une couche absorbante (AS) à base d'une couche mince et un agencement des deux systèmes de contact sur la face supérieure (OS), **caractérisé par** les étapes suivantes du procédé:
(I) application d'une couche de passivation de champ (FSF/BSF) et d'une couche absorbante (AS) sur un substrat (SU) ou un super substrat (SP),
(II) dépôt de points de contact sur la face supérieure (OS) de la couche absorbante (AS),
(III) exécution d'un recuit des points de contact pour la formation de trous métallisés (DK) sous la forme de pointes métalliques (MS),
(IV) dépôt d'une grille de contact (KG) sur la face supérieure de la couche absorbante (AS) tout en recouvrant les points de contact,
(IV) génération d'une couche d'isolation électrique (IS) sur l'ensemble de la surface de la grille de contact (KG),
(V) dépôt, sur toute la surface, d'une couche émettrice (ES) sur la face supérieure (OS) de la couche absorbante (AS) avec la grille de contact (KG) tout en passivant simultanément les zones dégagées de la couche absorbante (AS),
(VI) dépôt, sur toute la surface, d'une couche de contact (KS) sur la couche émettrice (ES) déposée, et
(VII) mise en contact électrique de la grille de contact (KG) et de la couche de contact (KS).

7. Procédé selon l'une des revendications 3 à 6, **caractérisé par** appliquer une couche de protection (OX) d'isolation électrique de surface complète sur la face supérieure (OS) de la couche absorbante avant l'application de la grille de contact (KG), obligatoirement en cas d'un trou métallisé de la couche émettrice (ES) et optionnellement en cas d'un trou métallisé d'une couche de passivation de champ (FSF/BSF), et libérer la face supérieure (OS) de la couche absorbante (AS) avec la grille de contact (KG) de la couche de protection (OX) d'isolation électrique avant le dépôt de la couche émettrice (ES) ou de la couche de passivation de champ (FSF/BSF) sans affecter la couche d'isolation (IS) sur la grille de contact (KG).

8. Procédé selon l'une des revendications 3 à 6, **caractérisé par** libérer la face supérieure (OS) de la couche absorbante (AS) avec la grille de contact (KG) de salissures avant le dépôt de la couche émettrice (ES) ou de la couche de passivation de champ (FSF/BSF) sans affecter la couche d'isolation (IS) sur la grille de contact (KG).

9. Procédé selon l'une des revendications 3 à 8, **caractérisé par** structurer la couche absorbante (AS) en générant des ouvertures de passage (DG) en forme de points, de lignes, de grilles, ou de réseaux grâce à un traitement de gravure ou au laser.

10. Procédé selon la revendication 9, **caractérisé par** remplir les ouvertures de passage (DG) avec un matériau électro-conducteur, moyennant quoi, au moins en cas d'un trou métallisé (DK) de la couche émettrice (ES), les ouvertures de passage (DG) sont préalablement revêtues d'un matériau d'isolation électrique (IM).

11. Procédé selon la revendication 10, **caractérisé par** remplir les ouvertures de passage (DG) avec un matériau semi-conducteur avec la même fonctionnalité que la couche émettrice (ES) ou la couche de passivation de champ (FSF/BSF).

12. Procédé selon l'une des revendications 3 à 11, **caractérisé par** former une nervure (ST) en tant que zone de jonction au bord de la couche absorbante (AS) lors du dépôt de la grille de contact (KG), évider la zone de jonction pendant le dépôt de la couche émettrice (ES) ou de la couche de passivation de champ (FSF/BSF) sur la face arrière de la couche absorbante (AS) et dégager la zone de jonction.

13. Procédé selon l'une des revendications 3 à 12, **caractérisé par** déposer de manière supplémentaire d'autres couches fonctionnelles (FS), en particulier également des couches tampon ou des couches d'ensemencement, grâce à une évaporation thermique, une pulvérisation cathodique ou un dépôt en phase gazeuse, des couches fonctionnelles individuelles (FS) pouvant présenter plusieurs fonctions.
